# EUROPEAN PATENT SPECIFICATION

(11) **EP 3 197 007 B1**
(45) Date of publication and mention of the grant of the patent: **06.03.2019**
(21) Application number: 15841391.4
(22) Date of filing: 18.09.2015
(51) Int. Cl.: H02J 7/02, H02J 7/00, G01R 31/36

(54) **CHARGING SYSTEM**
LADESYSTEM
SYSTÈME DE CHARGE

(30) Priority: 18.09.2014 JP 2014189771
(43) Date of publication of application: 26.07.2017
(73) Proprietor: Takashin Co., Ltd., Hirakawa-shi, Aomori 036-0114 (JP)
(72) Inventor: TANDAI, Tomohisa, Hirakawa-shi Aomori 036-0121 (JP); YOSHIOKA, Jun, Yamagata-shi Yamagata 990-2317 (JP); MIKAMI, Hiroaki, Hirakawa-shi Aomori 036-0242 (JP); KOGAWA, Jun, Minamitsugaru-gun Aomori 038-1211 (JP); FUJITA, Masaki, Hirakawa-shi Aomori 036-0115 (JP); AKAHIRA, Toshiki, Hirakawa-shi Aomori 036-0143 (JP)
(74) Representative: Haseltine Lake LLP
(86) International application number: PCT/JP2015/004804
(87) International publication number: WO 2016/042780

(56) References cited:
- WO-A1-2013/157186
- JP-A- 2002 216 855
- JP-A- 2007 185 023
- JP-A- 2009 201 276
- JP-A- 2009 201 276
- JP-U- H0 624 358
- US-A1- 2008 258 677
- US-A1- 2011 006 603
- US-A1- 2012 126 754

## Description

### [Technical Field]

The present invention relates to a charging system and, particularly, to the charging system that simultaneously charges rechargeable batteries of multiple devices to-be-charged (charge-scheduled devices) and maintains the multiple charge-scheduled devices, as in the case of medical devices in a hospital or the like.

### [Background Art]

In a situation that rechargeable batteries such as a lead-acid battery, a nickel cadmium (Ni-Cd) battery, a nickel metal hydride (Ni-MH) battery, and a lithium ion battery are used for medical devices, attention is necessary for not causing the over-discharge of the lead-acid battery, because the lead-acid battery has a characteristic such that an over-discharge of the lead-acid battery significantly degrades the performance of the lead-acid battery, and the degraded performance is not recovered. The nickel cadmium battery has a large self-discharge behavior, and creates a large memory effect of battery, therefore, routine maintenance of the states of the nickel cadmium battery is important. The nickel metal hydride battery is weak against the over-discharge, and the complete discharge degrades performance of the nickel metal hydride battery so as to cause a decrease in the battery capacity. In addition, since amount of the self-discharge of the nickel metal hydride battery is large, a routine checking of the charged state of the nickel metal hydride battery is significantly required. The lithium ion battery has a risk of abnormal overheat at the times of the over-discharge and the over-charge.

Particularly, corresponding to each of various kinds of medical devices, different kinds of rechargeable batteries are sometimes assigned, respectively. Therefore, a charging system which can calculate a proper discharging-period for each of the rechargeable batteries, and can automatically monitor and manage the battery capacities of the rechargeable batteries is required.

Therefore, in use situations of hospitals or the like where multiple medical devices are operating, a condition such that only specific medical devices having a short charging-period are selected frequently to be used, and other medical devices having a long charging-period tend to be not used for a long time will occur. In addition, a situation such that, when multiple charge-scheduled devices are simultaneously charged, each of the charging-periods of respective charge-scheduled devices will become longer than the charging-period of a single device when the single device is charged alone, as the respective supply powers are delivered to multiple devices, is known. Therefore, a scheme for selecting a predetermined charge-scheduled device so that the selected device is charged with priority when simultaneously charging a plurality of devices has been proposed, as recited in Patent Literature (PTL) 1. A charging system according to PTL 1, for example, power is supplied with priority to a specific charge-scheduled device, of which a battery remaining amount is the smallest among a plurality of charge-scheduled devices.

However, in the invention disclosed in PTL 1, since the degree of charging-priority is determined based on the ratio of the battery remaining amount of each charge-scheduled device, a problem that a device having a possibility of being scheduled to be used at the earliest, after the charging the plurality of charge-scheduled devices, cannot be determined among the plurality of charge-scheduled devices with the priority exists.

In the charging system that simultaneously charges multiple charge-scheduled devices for repetitive recharging, an efficient management of the charging, which facilitates consequently the sufficient battery performance, is required. Here, the efficient management of the charging shall optimize the charge cycles of built-in rechargeable batteries by averaging the use-frequencies, or the use-frequencies of built-in rechargeable batteries installed in the charge-scheduled devices, acquiring the sufficient charging-periods and the normal use-periods, or the normal discharging-periods for all of the charge-scheduled device.

PTL2 discloses a management method for charging secondary batteries of work vehicles.

### [Citation List]

### [Patent Literature]

PTL 1: JP 2007-089341 A
PTL 2: US 2012-0126754 A1

### [Summary of Invention]

### [Technical Problem]

An object of the present invention is to provide a charging system capable of simultaneously charging a plurality of charge-scheduled devices, capable of eliminating an erroneous operation such as failing of the start of charging, capable of accurately monitoring the charged statuses of the plurality of the charge-scheduled devices, capable of preventing imbalances in the use-frequencies of the devices ascribable to differences in the charging-period, and capable of individually managing the plurality of the charge-scheduled devices including the degradation of rechargeable batteries.

### [Solution to Problem]

In order to achieve the object described above, a first aspect of the present invention inheres in a charging system as defined in claim 1. Preferred features are defined in the dependent claims.

### [Advantageous Effects of Invention]

According to the present invention, a charging system capable of simultaneously charging a plurality of the charge-scheduled devices, capable of eliminating the erroneous operation such as failing of the start of charging, capable of accurately monitoring the charged statuses of the plurality of the charge-scheduled devices, capable of preventing the imbalances in the use-frequencies of the devices ascribable to differences in the charging-period, and capable of individually managing the plurality of the charge-scheduled devices including the degradation of rechargeable batteries can be provided.

### [Brief Description of Drawings]

Fig. 1 is a schematic side view that illustrates an overview of a major portion of a charging system according to a first embodiment of the present invention;
Fig. 2 is an enlarged side view that illustrates an uppermost stage illustrated in Fig. 1;
Fig. 3 is an enlarged top view that illustrates the uppermost stage illustrated in Fig. 1;
Fig. 4 is a schematic top view that illustrates an overview of a major portion of the charging system according to the first embodiment, corresponding to Fig. 1.
Fig. 5 is a block diagram that illustrates an overview of a major portion of a charging-state managing circuit used for the charging system according to the first embodiment;
Fig. 6 is a block diagram that illustrates an overview of a major portion of a state indicator used for the charging system according to the first embodiment;
Fig. 7 is a block diagram that illustrates an overview of a major portion of a predetermined period determining circuit used for the charging system according to the first embodiment;
Fig. 8 is a block diagram that illustrates a relation between the reference-charge-period determining-circuit and a charging-state displaying circuit used for the charging system according to the first embodiment;
Fig. 9 is a block diagram that illustrates an overview of a major portion of a charge-end-point detecting-circuit used for the charging system according to the first embodiment;
Fig. 10 is a waveform diagram that illustrates an operation of the charge-end-point detecting-circuit used for the charging system according to the first embodiment;
Fig. 11 is a flowchart (1) that illustrates an operation of the charging system according to the first embodiment;
Fig. 12 is a flowchart (2) that illustrates the operation of the charging system according to the first embodiment;
Fig. 13 is a flowchart (3) that illustrates the operation of the charging system according to the first embodiment;
Fig. 14 is a flowchart (4) that illustrates the operation of the charging system according to the first embodiment;
Fig. 15 is a flowchart (5) that illustrates the operation of the charging system according to the first embodiment;
Fig. 16 is a flowchart (6) that illustrates the operation of the charging system according to the first embodiment;
Fig. 17 is a schematic front view that illustrates an overview of a major portion of a charging system according to a second embodiment of the present invention;
Fig. 18 is an enlarged front view that illustrates a part of an uppermost stage illustrated in Fig. 17;
Fig. 19 is an enlarged front view that illustrates a state in which a charge-scheduled device is mounted in the uppermost stage illustrated in Fig. 17;
Fig. 20 is a block diagram that illustrates an overview of a major portion of a charging-state managing circuit used for a charging system according to the third embodiment;
Fig. 21 is a block diagram that illustrates an overview of a major portion of a charging-state determining-circuit used for the charging system according to the third embodiment;
Fig. 22 is a waveform diagram (1) that illustrates an operation of the charging-state determining-circuit used for the charging system according to the third embodiment;
Fig. 23 is a waveform diagram (2) that illustrates an operation of the charging-state determining-circuit used for the charging system according to the third embodiment;
Fig. 24 is a block diagram that illustrates an overview of a major portion of a charging-state determining-circuit used for the charging system according to the third embodiment;
Fig. 25 is a block diagram that illustrates a relation between the charging-state determining-circuit and a charging-state displaying circuit used for the charging system according to the third embodiment;
Fig. 26 is a flowchart that illustrates an operation of the charging system according to the third embodiment;
Fig. 27 is a block diagram that illustrates an overview of a major portion of a charging-state managing circuit used for a charging system according to a fourth embodiment;
Fig. 28 is a block diagram that illustrates an overview of a major portion of an EL fault determining-circuit used for the charging system according to the fourth embodiment;
Fig. 29 is a waveform diagram (1) that illustrates an operation of a charging-state determining-circuit used for the charging system according to the fourth embodiment;
Fig. 30 is a waveform diagram (2) that illustrates an operation of a charging-state determining-circuit used for the charging system according to the fourth embodiment;
Fig. 31 is a block diagram that illustrates an overview of a major portion of the EL fault determining-circuit used for the charging system according to the fourth embodiment;
Fig. 32 is a block diagram that illustrates a relation among the charging-state determining-circuit, the EL fault determining-circuit, and a charging-state displaying circuit used for the charging system according to the fourth embodiment;
Fig. 33 is a block diagram that illustrates a relation between the fault determining-circuit and the charging-state determining-circuit used for the charging system according to the fourth embodiment;
Fig. 34 is a flowchart (1) that illustrates an operation of the charging system according to the fourth embodiment; and
Fig. 35 is a flowchart (2) that illustrates an operation of the charging system according to the fourth embodiment.

### [Description of Embodiments]

Next, first to fourth embodiments of the present invention will be described with reference to the drawings. In description of the drawings illustrated below, the same or similar reference numerals are given to the same or similar elements. However, the drawings are schematic, and it should be noted that a relation between a thickness and a flat dimension, a ratio among thicknesses of layers, and the like are different from actual ones. Therefore, specific thicknesses and specific dimensions should be determined by referring to description presented below. In addition, portions of which the dimensional relations or ratios are different from each other are included in the drawings apparently.

The first to fourth embodiments described below represent devices and methods for realizing a technical idea of the present invention as examples, and the technical idea of the present invention does not specify the materials, shapes, structures, arrangements, and the like of constituent components to be the embodiments described presented below. According to the technical idea of the present invention, various changes may be made within a technical scope defined by the claims.

### (FIRST EMBODIMENT)

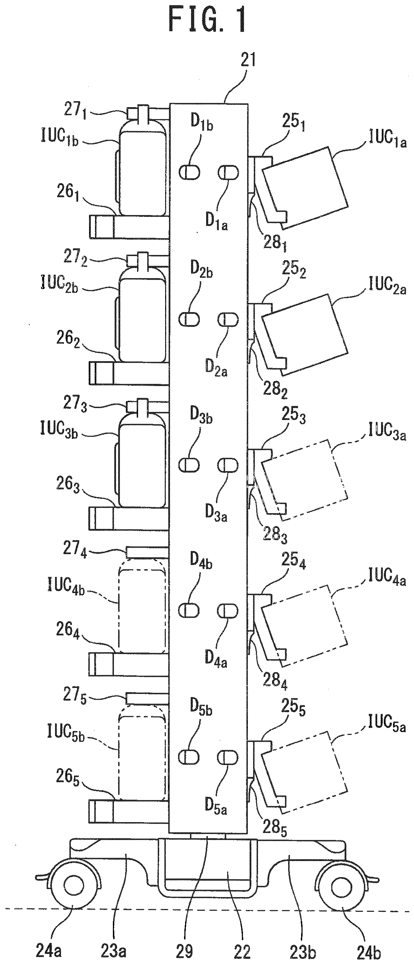

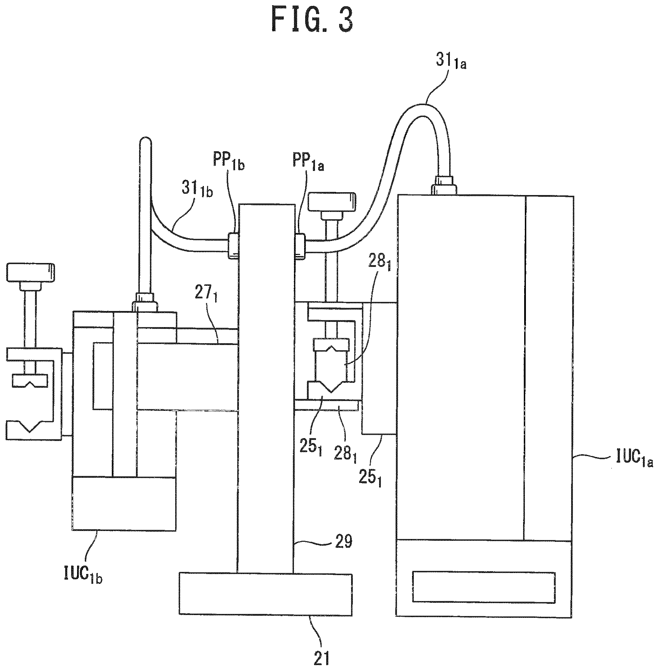

As illustrated in a side view of Fig. 1, in a charging system according to the first embodiment of the present invention, a plurality of charge-scheduled devices IUC₁ₐ, IUC₂ₐ, ..., IUC₅ₐ; IUC_{1b}, IUC_{2b}, ..., IUC_{5b} are arranged over side walls of a tower (21, 22, 23a, 23b, 23c, 23d, and 29), which extends in an elongated shape with a constant width. The tower (21, 22, 23a, 23b, 23c, 23d, and 29), a top view of which is illustrated in Fig. 3, includes a box-shaped display panel 21 extending in the height direction and a box-shaped pillar portion 29, which is connected to a center portion of one of the side faces of the display panel 21, such that a cross-sectional shape of the tower (21, 22, 23a, 23b, 23c, 23d, and 29) cut along a horizontal plane creates "T" shape. As illustrated in Fig. 3, because the top surface of the box-shaped display panel 21 extending in the height direction is recognized as a rectangular shape, the outer shape of the display panel 21 can be understood as a rectangular parallelepiped. The pillar portion 29, of which the shape of the top surface is a rectangle, is connected to a center portion of one of the side faces of the display panel 21, the one of the side faces corresponds to an upper plane of the rectangular illustrated in Fig. 3, so that the pillar portion 29 and the display panel 21 can implement the "T" shape as a shape viewed from the top. From the top view of Fig. 3, the outer shape of the pillar portion 29 can be recognized as a rectangular parallelepiped. As illustrated in Fig. 1, on the surface of the display panel 21, display portions D₁ₐ, D₂ₐ, ..., D₅ₐ; D_{1b}, D_{2b}, ..., D_{5b}, each of which displays "under-charging", "charge-completed", and "priority order", are sequentially assigned so as to be paired with the allocated positions of the plurality of the charge-scheduled devices IUC₁ₐ, IUC₂ₐ, ..., IUC₅ₐ; IUC_{1b}, IUC_{2b}, ..., IUC_{5b}.

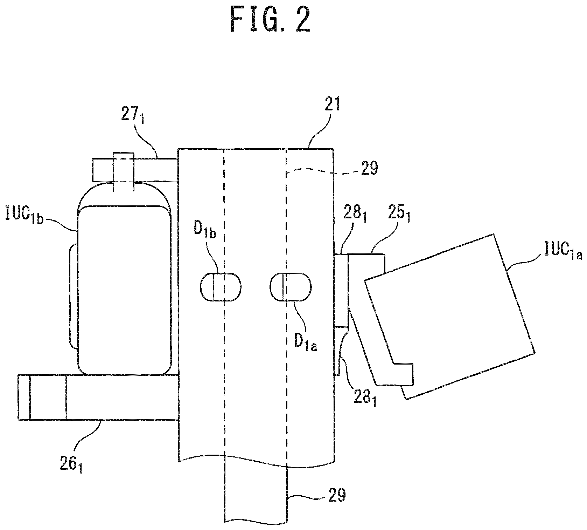

Fig. 2 is an enlarged view focusing on the charge-scheduled devices IUC₁ₐ and IUC_{1B} which are attached to the uppermost tier of the side view illustrated in Fig. 1. As illustrated in Fig. 2, the charge-scheduled device IUC₁ₐ is held by a support constituent element (25₁, 28₁) projecting from the pillar portion 29 toward the right side, and the charge-scheduled device IUC_{1b} is suspended at a suspension bar 27₁ overhanging from the pillar portion 29 toward the left side in the horizontal direction. While a mounting board 26₁ is represented as if the mounting board 26₁ overhangs from the pillar portion 29 toward the left side in the horizontal direction, actually, the mounting board 26₁ is attached to the bottom of the charge-scheduled device IUC_{1b}. The mounting board 26₁ is used when the charge-scheduled device IUC_{1b} is removed from the tower (21, 22, 23a, 23b, 23c, 23d, 29) so as to be attached to a pole prepared for transfusion instrument. In addition, as illustrated in Fig. 2, the display portion D₁ₐ displaying "under-charging", "charge-completed", and "priority order" of the charge-scheduled device IUC₁ₐ and the display portion D_{1b} displaying "under-charging", "charge-completed", and "priority order" of the charge-scheduled device IUC_{1b} are arranged on the surface of the display panel 21.

Fig. 3 is a top view corresponding to the side view illustrated in Fig. 2, and Fig. 3 illustrates a situation such that the charge-scheduled devices IUC₁ₐ and IUC_{1b} disposed in the uppermost tier are electrically connected to power-feeding portions PP₁ₐ and PP_{1b} disposed at the pillar portion 29, respectively, through power-feeding cables 31₁ₐ and 31_{1b}. The support constituent element (25₁, 28₁) holding the charge-scheduled device IUC₁ₐ is implemented by a grip 28₁ disposed on a side wall of the pillar portion 29 and a clamp 25₁ which pinch the grip 28₁, such that the clamp 25₁ can be separated from the grip 28₁ each other. The grip 28₁ is implemented by a support pole having a pentagonal shape, the support pole is disposed on the side wall of the pillar portion 29, and a plate-shaped stopper separated from the support pole by a constant length. Since the support pole having the pentagonal shape extends in a longitudinal direction, in the top view of Fig. 3, an apex of the pentagon can be observed. Meanwhile, the clamp 25₁ includes a vise mechanism and a hooking mechanism which is continuous from the vise mechanism. As base plates of the vise mechanism of the clamp 25₁ pinches the support pole having the pentagonal shape of the grip 28₁ from both sides so that the clamp 25₁ can be fixed to the grip 28₁. As illustrated in Fig. 2, the charge-scheduled device IUC₁ₐ is held by a hook-shaped structure implemented by the hooking mechanism of the clamp 25₁.

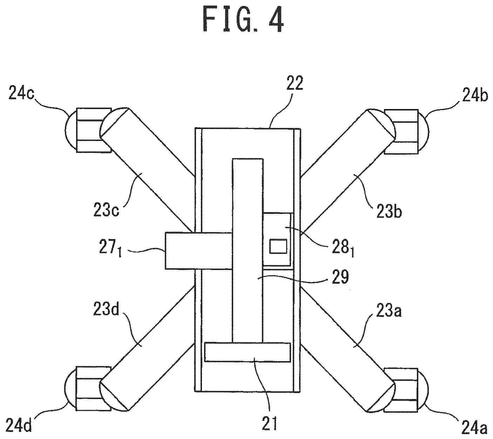

As illustrated in a top view of Fig. 4, the tower (21, 22, 23a, 23b, 23c, 23d, and 29) respectively includes legs 23a, 23b, 23c, and 23d, each of the longitudinal directions of legs 23a, 23b, 23c, and 23d intersects with each other so as to implement the shape of "X". Moving wheels 24a, 24b, 24c, 24d are respectively provided at tip ends of the legs 23a, 23b, 23c, and 23d. The tower (21, 22, 23a, 23b, 23c, 23d, and 29) is freely movable using the moving wheels 24a, 24b, 24c, and 24d.

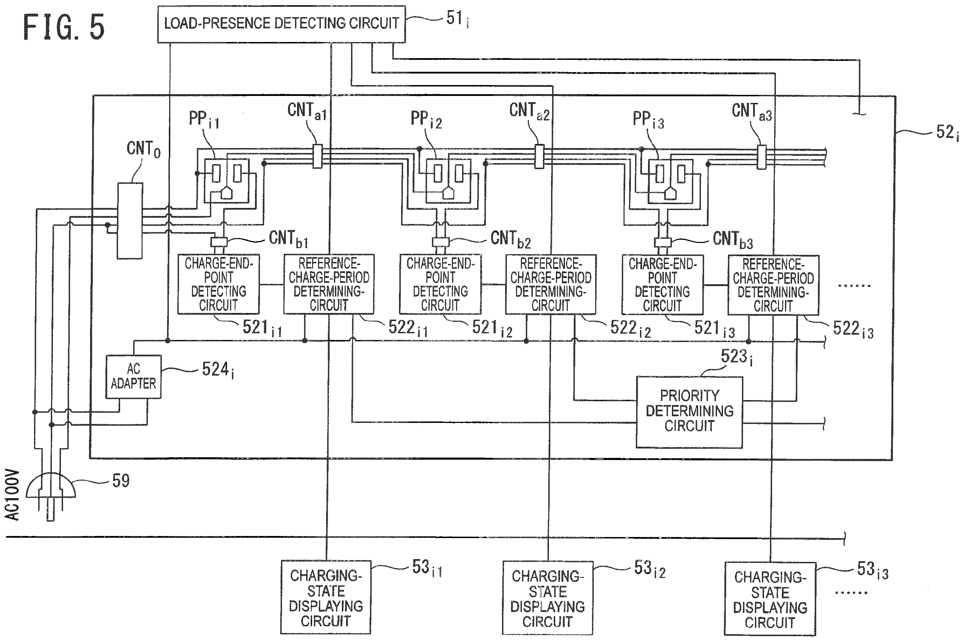

In Fig 3, although only the power-feeding units PP₁ₐ and PP_{1b} feeding power to the charge-scheduled devices IUC₁ₐ and IUC_{1b}, which are disposed in the uppermost tier, are illustrated as an example, the charging system according to the first embodiment can be represented as a structure including a plurality of power-feeding units PPᵢ₁, PPᵢ₂, PPᵢ₃, ...... corresponding to the number of the plurality of the charge-scheduled devices IUC₁ₐ, IUC₂ₐ, ..., IUC₅ₐ; IUC_{1b}, IUC_{2b}, ..., IUC_{5b} facilitating the electrical connection to the plurality of the charge-scheduled devices IUC₁ₐ, IUC₂ₐ, ..., IUC₅ₐ; IUC_{1b}, IUC_{2b}, ..., IUC_{5b} in a more general representation as illustrated in Fig. 5. In Fig. 5, when scripts of the reference numerals are defined as i1=1a, i2=2a, ......; (i+1)1=1b, (i+1)2=2b, ......, each of the structure elements illustrated in Fig. 5 corresponds to the structure elements illustrated in Fig. 1, respectively. However, depending on the use situations, a configuration such that a plurality of the charge-scheduled devices IUC₁ₐ, IUC₂ₐ, ..., IUC₅ₐ; IUC_{1b}, IUC_{2b}, ..., IUC_{5b}, the number of which corresponds to a value less than the number of power-feeding units PPᵢ₁, PPᵢ₂, PPᵢ₃, ......, are assigned, and therefore an empty space is created in the power-feeding units PPᵢ₁, PPᵢ₂, PPᵢ₃, ......, may be available.

In other words, a charging-state managing circuit 52ᵢ of the charging system according to the first embodiment, as illustrated in Fig. 5, includes charge-end-point detecting-circuits 521ᵢ₁, 521ᵢ₂, 521ᵢ₃, ...... which independently measure changes of currents supplied to charge-scheduled devices, which are not illustrated and to be referred to IUC₁ₐ, IUC₂ₐ, ..., IUC₅ₐ; IUC_{1b}, IUC_{2b}, ..., IUC_{5b}, and the like illustrated in Fig. 1, from commercial power through the plurality of power-feeding units PPᵢ₁, PPᵢ₂, PPᵢ₃, ...... and detect charging-start timings and charging-end timings for the charge-scheduled devices; reference-charge-period determining-circuits 522ᵢ₁, 522ᵢ₂, 522ᵢ₃, ...... which receive information of the charging-start timings from the charge-end-point detecting-circuits 521ᵢ₁, 521ᵢ₂, 521ᵢ₃, ...... and measure reference-charge-periods, which are determined in advance, from the charging-start timings of the charge-scheduled devices, and a priority-determining circuit 523ᵢ which determines priority in the use order of a plurality of the charge-scheduled devices based on the charging-periods of the charge-scheduled devices under a condition such that a plurality of the charge-scheduled devices, including the charge-scheduled devices which has completed the charging, are connected to a plurality of power-feeding units PPᵢ₁, PPᵢ₂, PPᵢ₃, ....... The charging-state managing circuit 52ᵢ implementing the charging system according to the first embodiment is connected to charging-state display circuits 53ᵢ₁, 53ᵢ₂, 53ᵢ₃, ...... displaying whether each of a plurality of the charge-scheduled devices is in "under-charging" or "charge-completed". The charging-state display circuits 53ᵢ₁, 53ᵢ₂, 53ᵢ₃, ...... further displays the priority in the use order of the plurality of the charge-scheduled devices.

In Fig. 2, while the display portion D₁ₐ displaying "under-charging", "charge-completed " and the priority order of the charge-scheduled device IUC₁ₐ, and the display portion D_{1b} displaying "under-charging", "charge-completed " and the priority order of the charge-scheduled device IUC_{1b} are illustrated as an example, the display portions D₁ₐ, D₂ₐ, ..., D₅ₐ; D_{1b}, D_{2b}, ..., D_{5b} disposed on the surface of the display panel 21 are assigned so as to be paired with a plurality of power-feeding units, which are not illustrated, disposed over the side wall of the pillar portion 29 implementing the tower (21, 22, 23a, 23b, 23c, 23d, and 29).

As illustrated in Fig. 5, each of the plurality of power-feeding units PPᵢ₁, PPᵢ₂, PPᵢ₃, ...... of the charging system according to the first embodiment, for example, can be implemented by a bipolar socket with grounding appliance. The plurality of power-feeding units PPᵢ₁, PPᵢ₂, PPᵢ₃, ...... are connected in series through connectors CNTₐ₁, CNTₐ₂, CNTₐ₃, ....... The leading power-feeding unit PPᵢ₁ is electrically connected to an AC power plug 59 through a connector CNT₀ and commercial power is supplied.

Among single-phase three lines extending from the AC power plug 59 supplying the commercial power, one of the voltage lines branches before the connector CNT₀ so that four lines can be plugged to the connector CNT₀ (hereinafter the one of the voltage lines is called " the first voltage line"). One of the branched lines from the first voltage line passes through the connector CNT₀ and then, is plugged to the charge-end-point detecting-circuit 521ᵢ₁ through the connector CNT_{b1}, and another one of the branched lines from the first voltage line is directly connected to the connector CNTₐ₁ and extends up to the power-feeding unit PPᵢ₂ of a next tier through the connector CNTₐ₁. The one of the branched lines from the first voltage line, which is plugged to the charge-end-point detecting-circuit 521ᵢ₁, is connected to one pole in the outlet-terminals (hereinafter called "the first outlet terminal" of the bipolar socket with grounding appliance through the connector CNT_{b1}, and the other one of the voltage lines (hereinafter called " the second voltage line") implementing the single-phase three lines is connected to another one pole in the outlet-terminals (hereinafter called " the second outlet terminal" of the bipolar socket with grounding appliance through the connector CNT₀. In addition, earth wire is connected to an outlet terminal for the grounding pole (hereinafter called "grounding terminal" hereinafter) of the bipolar socket with grounding appliance through the connector CNT₀.

Among four lines extending from the connector CNT₀, the first voltage line branches before the connector CNTₐ₁, and four lines are plugged to the connector CNTₐ₁. One of the branched first voltage lines passes through the connector CNTₐ₁ and then, is plugged to the charge-end-point detecting-circuit 521ᵢ₂ through the connector CNT_{b2}, and the other one of the branched first voltage lines is directly connected to the connector CNTₐ₂ and extends up to the power-feeding unit PPᵢ₃ of a next tier through the connector CNTₐ₂. The one of the branched first voltage lines, which is plugged to the charge-end-point detecting-circuit 521ᵢ₂, is connected to the first outlet terminal of the bipolar socket with grounding appliance through the connector CNTb2, and the second voltage line implementing the single-phase three lines passes through the connector CNTₐ₁ and then, branches, and one of the branched second voltage lines is connected to the second outlet terminal of the bipolar socket with grounding appliance. In addition, the grounding wire is connected to the grounding terminal of the bipolar socket with grounding appliance through the connector CNTₐ₁. The other one of the branched second voltage lines, which has branched after passing through the connector CNTₐ₁, is directly connected to the connector CNTₐ₂.

Among four lines extending from the connector CNTₐ₁, the first voltage line branches before the connector CNTₐ₂, and four lines are plugged to the connector CNTₐ₂. One of the branched first voltage lines passes through the connector CNTₐ₂ and then, is plugged to the charge-end-point detecting-circuit 521ᵢ₃ through the connector CNT_{b3}, and the other one of the branched first voltage lines is directly connected to the connector CNTₐ₃ and extends up to a power-feeding unit, which are not illustrated, of a next tier through the connector CNTₐ₃. The one of the branched first voltage lines, which is plugged to the charge-end-point detecting-circuit 521ᵢ₃, is connected to the first outlet terminal of the bipolar socket with grounding appliance through the connector CNT_{b3}, and the second voltage line implementing the single-phase three lines passes through the connector CNTₐ₂ and then, branches, and one of the branched second voltage lines is connected to the second outlet terminal of the bipolar socket with grounding appliance. In addition, the grounding wire is connected to the grounding terminal of the bipolar socket with grounding appliance through the connector CNTₐ₂. The other of the second voltage lines, which has branched after passing through the connector CNTₐ₂, is directly connected to the connector CNTₐ₃.

The charge-end-point detecting-circuit 521ᵢ₁ is connected to the reference-charge-period determining-circuit 522ᵢ₁, the charge-end-point detecting-circuit 521ᵢ₂ is connected to the reference-charge-period determining-circuit 522ᵢ₂, and the charge-end-point detecting-circuit 521ᵢ₃ is connected to the reference-charge-period determining-circuit 522ᵢ₃. In addition, the reference-charge-period determining-circuits 522ᵢ₁, 522ᵢ₂, 522ᵢ₃, ...... are connected to the priority-determining circuit 523ᵢ, the reference-charge-period determining-circuit 522ᵢ₁ is connected to the charging-state displaying circuit 53ᵢ₁, the reference-charge-period determining-circuit 522ᵢ₂ is connected to the charging-state displaying circuit 53ᵢ₂, and the reference-charge-period determining-circuit 522ᵢ₃ is connected to the charging-state displaying circuit 53ᵢ₃.

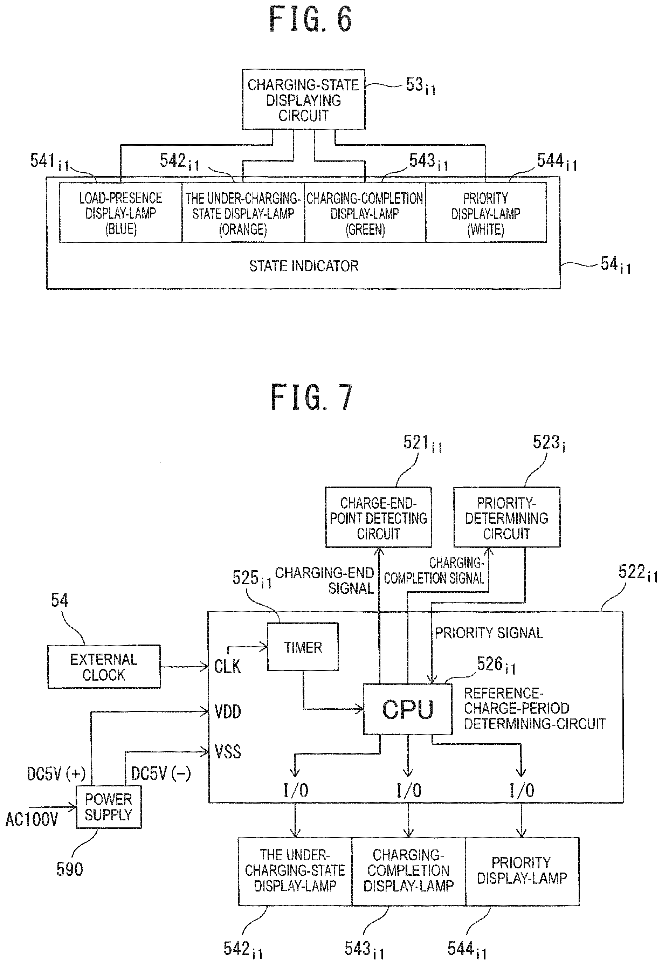

As illustrated in Fig. 5, the charging-state managing circuit 52ᵢ of the charging system according to the first embodiment is further connected to a load-presence detecting circuit 51ᵢ, and the output of the load-presence detecting circuit 51ᵢ is distributed to the corresponding reference-charge-period determining-circuits 522ᵢ₁, 522ᵢ₂, 522ᵢ₃, ...... installed in the charging-state managing circuit 52ᵢ, respectively. Then, in order to display the under-charging state of a charge-scheduled device, the charge-completed state of the charge-scheduled device, and the priority order of the charge-scheduled device, or the priority level of the use-order, the charging-state displaying circuit 53ᵢ₁, as illustrated in Fig. 6, is connected to a under-charging-state display-lamp 542ᵢ₁ of orange, a charge-completion display-lamp 543ᵢ₁ of green, and a priority display-lamp 544ᵢ₁ of white. When the under-charging-state display-lamp 542ᵢ₁ of orange is turned on, a charge-scheduled device which is disposed on the side or at the nearest position of under-charging-state display-lamp 542ᵢ₁ is prohibited from being taken out. In addition, in order to display the load-presence state of a charge-scheduled device, the charging-state displaying circuit 53ᵢ₁ is also connected to a load-presence display-lamp 541ᵢ₁ of blue. The load-presence display-lamp 541ᵢ₁ of blue, the under-charging-state display-lamp 542ii of orange, the charge-completion display-lamp 543ᵢ₁ of green, and the priority display-lamp 544ᵢ₁ of white, as illustrated in Fig. 6, are housed in a state indicator 54ᵢ₁ so as to implement the display portions D₁ₐ, D₂ₐ, ..., D₅ₐ; D_{1b}, D_{2b}, ..., D_{5b} (i1=1a, i2=2a, ......; (i+1)1=1b, (i+1)2=2b, ......) illustrated in Fig. 1. The other charging-state displaying circuits 53ᵢ₂, 53ᵢ₃, ...... drive similarly the lamps of corresponding display portions, respectively, as the charging-state displaying circuits 53ᵢ₂, 53ᵢ₃, ...... are similarly connected to the lamps of corresponding display portions, although each of the illustration of the connection relations is omitted.

Since the charging system according to the first embodiment includes the load-presence detecting circuit 51ᵢ, when both signals of a load-presence detecting signal transmitted from the load-presence detecting circuit 51ᵢ and a current-detecting signal transmitted from the corresponding charge-end-point detecting-circuits 521ᵢ₁, 521ᵢ₂, 521ᵢ₃, ...... are fed, each of the reference-charge-period determining-circuits 522ᵢ₁, 522ᵢ₂, 522ᵢ₃...... counts a predetermined period --for example, 15 hours-- and, after the end of the counting, transfers a completion signal to the priority-determining circuit 523ᵢ. When a state such that the current-detecting signal is not fed to the reference-charge-period determining-circuits 522ᵢ₁, 522ᵢ₂, although the load-presence detecting signal is fed to the reference-charge-period determining-circuits 522ᵢ₁, 522ᵢ₂, 522ᵢ₃......ⱼ, 522ᵢ₃...... from the load-presence detecting circuit 51ᵢ, continues ten minutes, for example, the counting of the predetermined period is skipped. And any one of the reference-charge-period determining-circuits 522ᵢ₁, 522ᵢ₂, 522ᵢ₃......, in which the counting of the predetermined period is skipped, provides a charging-completion signal. In the predetermined period of counting, if the feed of the load-presence detecting signal from the load-presence detecting circuit 51ᵢ disappears, a warning signal against taking-out is displayed, by blinking the under-charging-state display-lamp 542ᵢ₁ of orange.

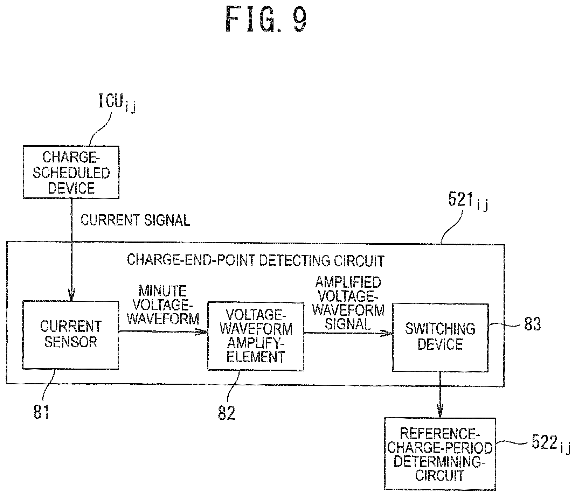

The charge-end-point detecting-circuit 521ᵢⱼ (j=1, 2, 3, ......), as illustrated in Fig. 9, includes a current sensor 81 which is connected to a charge-scheduled device IUCᵢⱼ (j=1, 2, 3, ......), a voltage-waveform amplify-element 82 which is connected to the current sensor 81, and a switching device 83 which is connected to the voltage-waveform amplify-element 82. The output of the switching device 83 is connected to the reference-charge-period determining-circuit 522ᵢⱼ (j=1, 2, 3, ......).

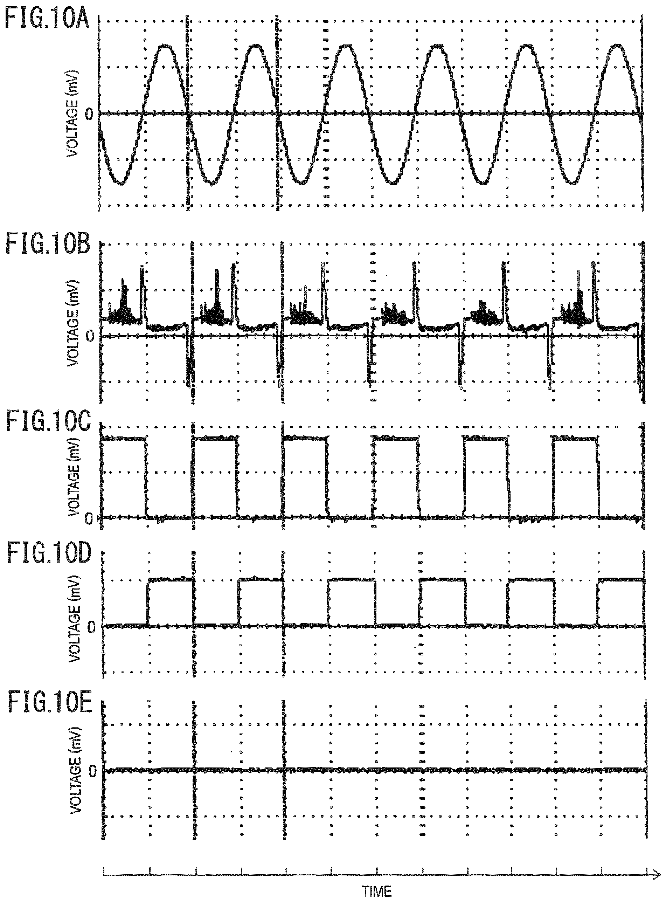

During the charging of the charge-scheduled device IUCᵢⱼ, as illustrated in Fig. 10A, a current signal of a sinusoidal wave is fed from the charge-scheduled device IUCᵢⱼ to the current sensor 81, and the current sensor 81 transfers a minute voltage-waveform at a maximum value and a minimum value as illustrated in Fig. 10B. The voltage-waveform amplify-element 82 which has received the minute voltage-waveform as an input, as illustrated in Fig. 10C, transfers an amplified voltage-waveform signal obtained by amplifying the positive-side amplitude of the minute voltage-waveform up to a voltage level by which the switching device 83 can be driven. The switching device 83 which has received the amplified voltage-waveform signal from the voltage-waveform amplify-element 82 as an input is driven according to the positive-side waveform voltage of the amplified voltage-waveform signal and transfers a charging-state-signal waveform of a square wave matching the reference-charge-period determining-circuit 522ᵢⱼ as illustrated in Fig. 10D. In other words, when the charging of the charge-scheduled device IUCᵢⱼ is started, the charge-end-point detecting-circuit 521ᵢⱼ detects a charging-current and transfers a charging-state-signal waveform of a square wave as illustrated in Fig. 10D, and, when the square wave is detected, for example, 20 times, the reference-charge-period determining-circuit 522ᵢⱼ determines that the charge-scheduled device IUCᵢⱼ is in a charged state.

Meanwhile, when the charging of the charge-scheduled device IUCᵢⱼ completes, the current sensor 81 cannot detect a current signal of the sinusoidal wave, therefore, the switching device 83 transfers a waveform as illustrated in Fig. 10E. Accordingly, the reference-charge-period determining-circuit 522ᵢⱼ cannot detect a square wave and determines that the charged state of the charge-scheduled device IUCᵢⱼ has completed.

Focusing on the reference-charge-period determining-circuit 522ᵢ₁, the reference-charge-period determining-circuit 522ᵢ₁, as illustrated in Fig. 7, includes a microprocessor (CPU) 526ᵢ₁ which implements an arithmetic operation, and a timer (internal clock) 525ᵢ₁ which sets reference-charge-periods required for a plurality of charge-scheduled devices IUC₁ₐ, IUC₂ₐ, ..., IUC₅ₐ; IUC_{1b}, IUC_{2b}, ..., IUC_{5b}. The timer 525ᵢ₁ illustrated in Fig. 7, for example, can be set by 15 hours. The timer 525ᵢ₁ counts by use of clock signals transmitted from an external clock 54. As described above, the reference-charge-period determining-circuit 522ᵢ₁ is connected to the charge-end-point detecting-circuit 521ᵢ₁, and a charging-end signal is transmitted from a CPU 526ᵢ₁ of the reference-charge-period determining-circuit 522ᵢ₁ to the charge-end-point detecting-circuit 521ᵢ₁. In addition, the reference-charge-period determining-circuit 522ᵢ₁ is connected to the priority-determining circuit 523ᵢ, a charging-completion signal is transmitted from the CPU 526ᵢ₁ of the reference-charge-period determining-circuit 522ᵢ₁ to the priority-determining circuit 523ᵢ, and the CPU 526ᵢ₁ receives a priority signal representing a priority order from the priority-determining circuit 523ᵢ. Although the charging-state displaying circuit 53ᵢ₁ is not illustrated, the CPU 526ᵢ₁ of the reference-charge-period determining-circuit 522ᵢ₁ passes through I/O interfaces and then, is connected to the under-charging-state display-lamp 542ᵢ₁, the charge-completion display-lamp 543ᵢ₁, and the priority display-lamp 544ᵢ₁ through the charging-state displaying circuit 53ᵢ₁, and the CPU 526ᵢ₁ drives the under-charging-state display-lamp 542ᵢ₁, the charge-completion display-lamp 543ᵢ₁, and the priority display-lamp 544ᵢ₁ through the I/O interfaces, and displays the under-charging state or the charge-completed state of a charge-scheduled device and displays the priority order of the charge-scheduled device. Since the feed of electric power to the reference-charge-period determining-circuit 522ᵢ₁ can be started at timing when a power supply 590 operates, an on/off button dedicated for controlling the feed of electric power to the reference-charge-period determining-circuit 522ᵢ₁ or a means or the like equivalent to the on/off button is unnecessary. The other reference-charge-period determining-circuits 522ᵢ₂, 522ᵢ₃, ...... are built up similar to what is illustrated in Fig. 7, although the illustration of the other reference-charge-period determining-circuits 522ᵢ₂, 522ᵢ₃, ...... is omitted, and each of the reference-charge-period determining-circuits 522ᵢ₂, 522ᵢ₃, ...... drives lamps of a corresponding display portion by using a similar configuration and a similar operation.

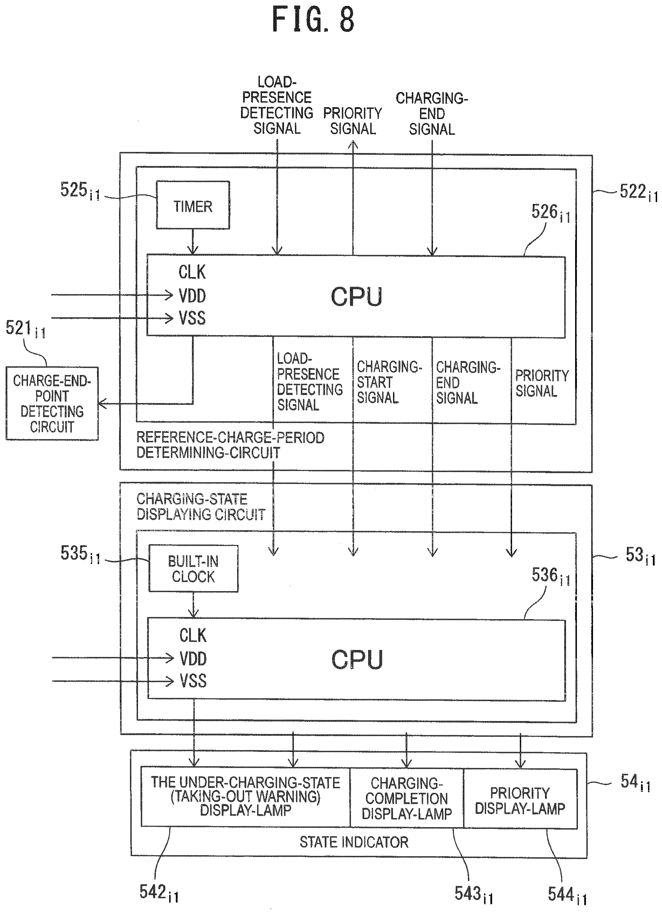

Fig. 8 illustrates transmission of the load-presence detecting signal, the charging-start signal, the charging-end signal, and the priority signal from the CPU 526ᵢ₁ of the reference-charge-period determining-circuit 522ᵢ₁ to the charging-state displaying circuit 53ᵢ₁, which are not illustrated in Fig. 7. Similar to the reference-charge-period determining-circuit 522ᵢ₁, the charging-state displaying circuit 53ᵢ₁ includes a microprocessor (CPU) 536ᵢ₁ which executes an arithmetic operation, and a built-in clock 535ᵢ₁. The load-presence detecting signal, the charging-start signal, the charging-end signal, and the priority signal are transmitted from the CPU 536ᵢ₁ to the under-charging-state display-lamp 542ᵢ₁, the charge-completion display-lamp 543ᵢ₁, and the priority display-lamp 544ᵢ₁ of the state indicator 54ᵢ₁ understood. Transmission of signals from the reference-charge-period determining-circuit 522ᵢ₂ to the charging-state displaying circuit 53ᵢ₂, and transmission of signals from the reference-charge-period determining-circuit 522ᵢ₃ to the charging-state displaying circuit 53ᵢ₁, and the like are similarly performed, and each lamp of display portions implemented by a state indicator 54ᵢ₂ and a state indicator 54ᵢ₃, ...... are driven, although the illustration of the transmission of signals is omitted.

According to the charging system of the first embodiment, because the load-presence detecting circuit 51ᵢ and the reference-charge-period determining-circuits 522ᵢ₁, 522ᵢ₂, 522ᵢ₃, ...... are included in the charging system, the procedure of turning on the switch at the time of starting charging and the procedure of turning off the switch at the time of taking out the device is unnecessary, and furthermore, the installation of on/off buttons and the like into the charging system is unnecessary. Therefore, a fault such that the turns on of the switch starts on its own, while the charge-scheduled device IUCᵢⱼ is not connected to the charging system, will not occur, and no fault of determining the priority order exists. According to the charging system of the first embodiment, the feed of electric power to the reference-charge-period determining-circuit 522ᵢ₁ is controlled to be on/off by using the load-presence detecting circuit 51ᵢ and the charge-end-point detecting-circuit 521ᵢ₁, therefore, by connecting the power-feeding units PPᵢ₁, PPᵢ₂, PPᵢ₃, ...... to the charge-scheduled devices IUCᵢⱼ, and just mounting the charge-scheduled devices IUCᵢⱼ at designated locations, the charging can be started. Therefore, the start of charging of the charge-scheduled device IUCᵢⱼ will not be carelessly forgotten.

In addition, according to the charging system of the first embodiment, a charging system can be provided which is capable of simultaneously charging a plurality of charge-scheduled devices IUC₁ₐ, IUC₂ₐ, ..., IUC₅ₐ; IUC_{1b}, IUC_{2b}, ..., IUC_{5b} and capable of individually managing the plurality of charge-scheduled devices IUC₁ₐ, IUC₂ₐ, ..., IUC₅ₐ; IUC_{1b}, IUC_{2b}, ..., IUC_{5b}. Here, the individual managing includes the accurate monitoring of the charged statuses of the plurality of charge-scheduled devices IUC₁ₐ, IUC₂ₐ, ..., IUC₅ₐ; IUC_{1b}, IUC_{2b}, ..., IUC_{5b} and the protection of occurrence of the imbalances in the use-frequencies of the plurality of charge-scheduled devices IUC₁ₐ, IUC₂ₐ, ..., IUC₅ₐ; IUC_{1b}, IUC_{2b}, ..., IUC_{5b}, which is ascribable to the differences in the charging-period, so as to protect the degradation of rechargeable batteries.

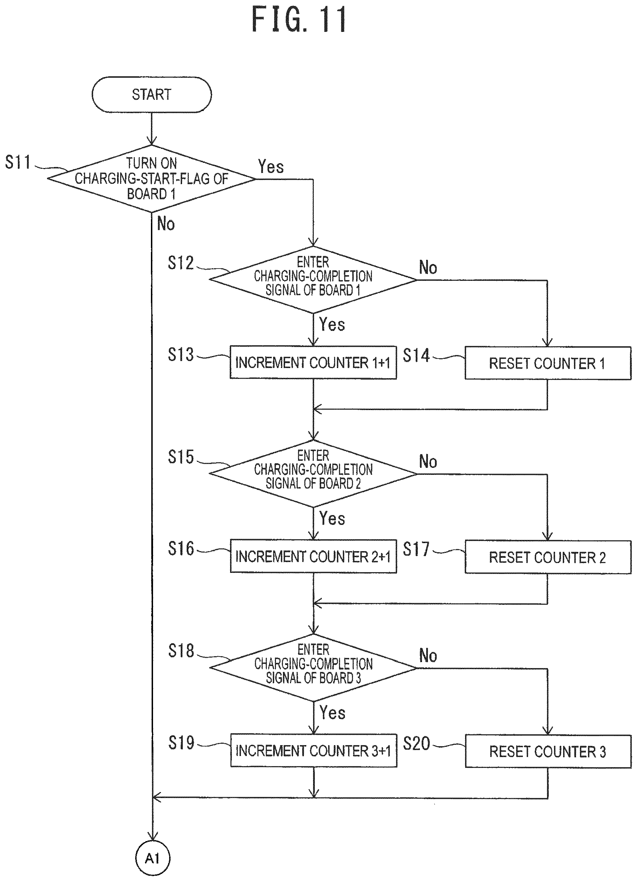

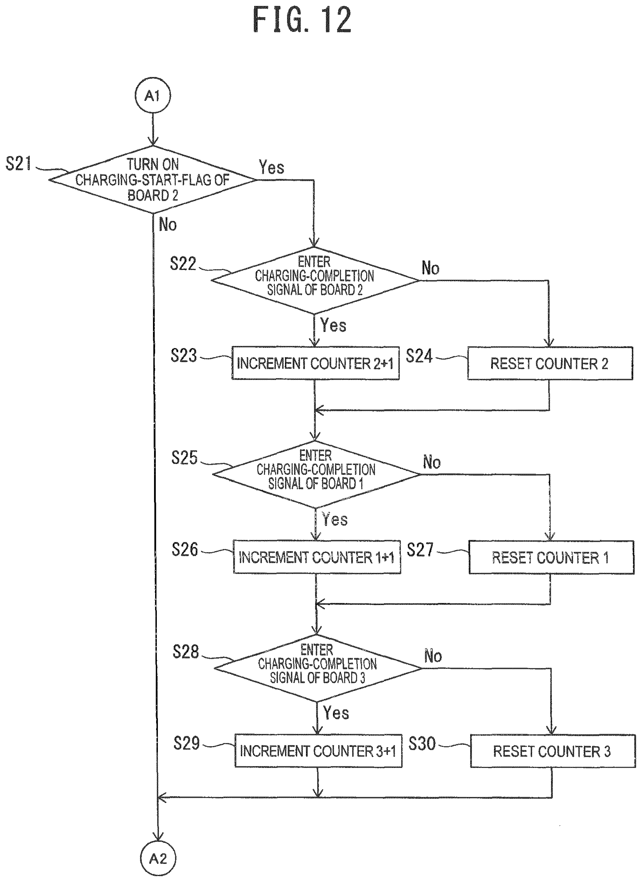

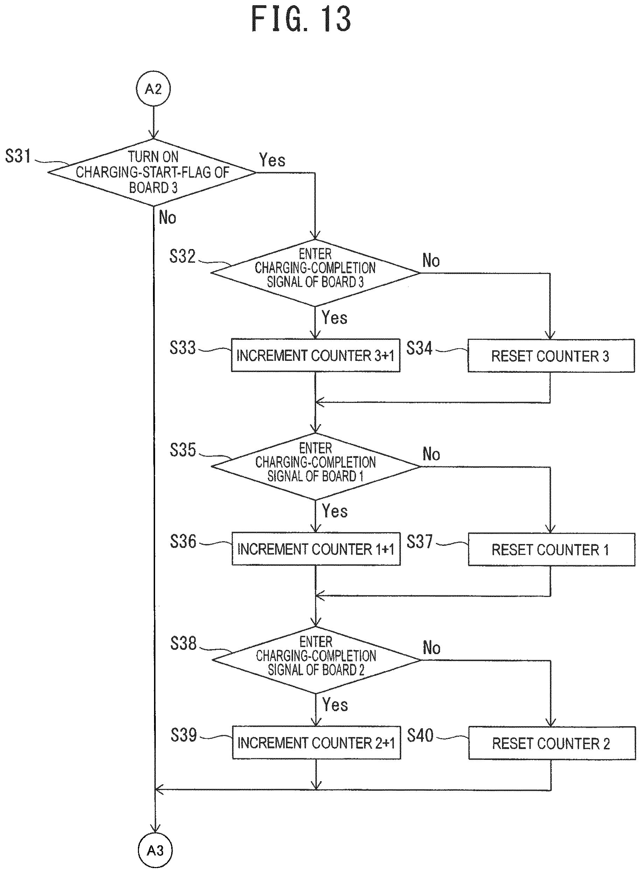

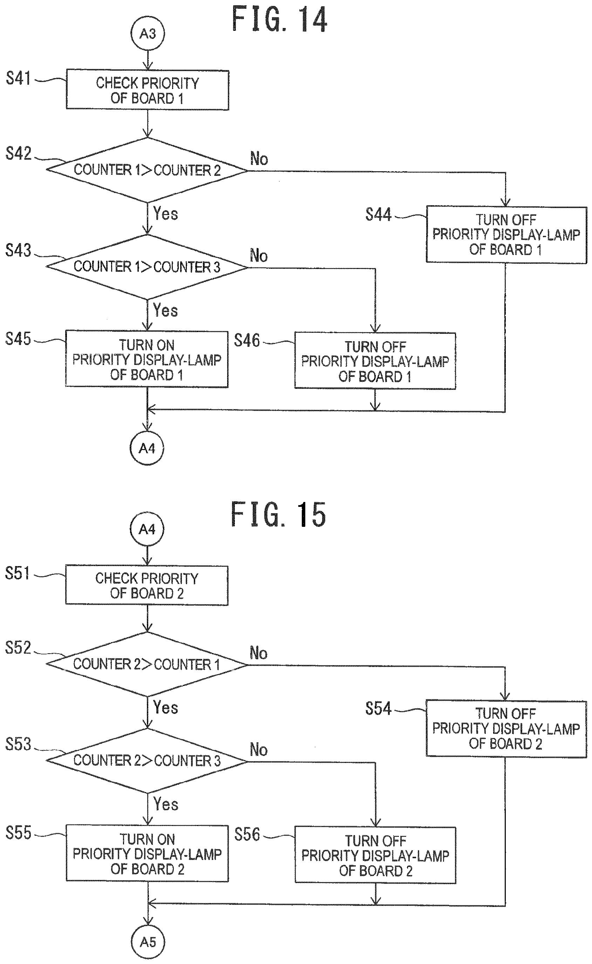

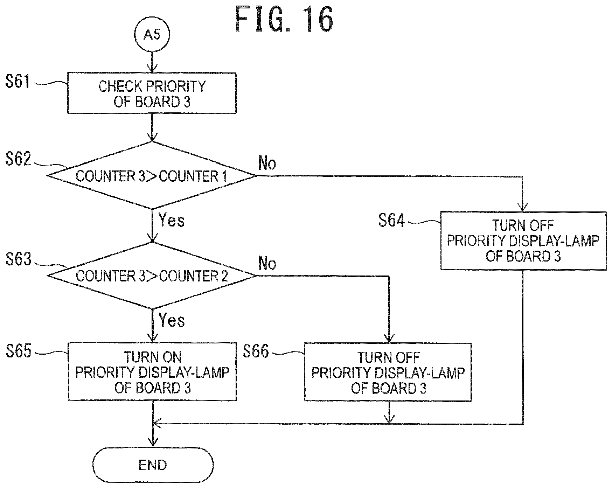

The operation of the charging system according to the first embodiment of the present invention will be described with reference to flowcharts illustrated in Figs. 11 to 16. The operation of the charging system described below is an example, and can be realized using other various operation methods including the modified examples as long as the modified examples are within the technical scope prescribed by the claims. In the flowcharts illustrated in Figs. 11 to 16, because less words are required by the restrictions of the limited space of the frames on the drawings, the "reference-charge-period determining-circuit 522ᵢ₁", the reference-charge-period determining-circuit 522ᵢ₂", and the "reference-charge-period determining-circuit 522ᵢ₃" are represented as "board 1", "board 2", and "board 3", respectively.
(a) First, in Step S11 illustrated in Fig. 11, the reference-charge-period determining-circuit 522ᵢ₁ determines whether or not the charging-start-flag on a software program of the priority-determining circuit 523ᵢ is put up. If the charging-start-flag is not put up, the flow proceeds to Step S21 illustrated in Fig. 12. If the reference-charge-period determining-circuit 522ᵢ₁ determines that the charging-start-flag of the priority-determining circuit 523ᵢ is put up in Step S11, the flow proceeds to Step S12.
(b) In Step S12, whether the reference-charge-period determining-circuit 522ᵢ₁ has entered a charging-completion signal to the priority-determining circuit 523ᵢ or not is determined. If the charging-completion signal has been fed, the flow proceeds to Step S13, and the reference-charge-period determining-circuit 522ᵢ₁ transfers a count up signal to the priority-determining circuit 523ᵢ and advances a counter on a software program of the priority-determining circuit 523i by one, and the flow proceeds to Step S15. If the reference-charge-period determining-circuit 522ᵢ₁ has not received the charging-completion signal is determined in Step S12, the flow proceeds to Step S14. The reference-charge-period determining-circuit 522ᵢ₁ transfers a counter-reset signal to the priority-determining circuit 523ᵢ and resets the counter on the software program of the priority-determining circuit 523ᵢ, and then, the flow proceeds to Step S15. By resetting the counter, when one of the charge-scheduled devices IUC₁ₐ, IUC₂ₐ, ..., IUC₅ₐ; IUC_{1b}, IUC_{2b}, ..., IUC_{5b} is removed before the under-charging-state display-lamp or the priority display-lamp is turned on, it is configured such that no influence will affect to the comparison procedure of the priority levels.
(c) In Step S15, whether the reference-charge-period determining-circuit 522ᵢ₂ has entered the charging-completion signal to the priority-determining circuit 523ᵢ or not is determined. If the charging-completion signal has been fed, the flow proceeds to Step S16, the reference-charge-period determining-circuit 522ᵢ₂ transfers a count up signal to the priority-determining circuit 523ᵢ and advances the counter on the software program of the priority-determining circuit 523ᵢ by one, and the flow proceeds to Step S18. If the reference-charge-period determining-circuit 522ᵢ₂ has not transferred the charging-completion signal is determined in Step S15, the flow proceeds to Step S17. The reference-charge-period determining-circuit 522ᵢ₂ transfers a counter-reset signal to the priority-determining circuit 523ᵢ and resets the counter on the software program of the priority-determining circuit 523ᵢ, and then, the flow proceeds to Step S18.
(d) In Step S18, whether the reference-charge-period determining-circuit 522ᵢ₃ has entered the charging-completion signal to the priority-determining circuit 523ᵢ or not is determined. If the charging-completion signal has been fed, the flow proceeds to Step S19, the reference-charge-period determining-circuit 522ᵢ₃ transfers a count up signal to the priority-determining circuit 523ᵢ and advances the counter on the software program of the priority-determining circuit 523ᵢ by one, and the flow proceeds to Step S21 illustrated in Fig. 12. If the reference-charge-period determining-circuit 522ᵢ₃ has not transferred the charging-completion signal is determined in Step S18, the flow proceeds to Step S20. The reference-charge-period determining-circuit 522ᵢ₃ transfers the counter-reset signal to the priority-determining circuit 523ᵢ and resets the counter on the software program of the priority-determining circuit 523ᵢ, and then, the flow proceeds to Step S21. As mentioned above, in Step S11 illustrated in Fig. 11, when the charging-start-flag is detected, in Steps S12, S15, and S18, the charge completion is monitored, and counters 1, 2, and 3 are increased at timing when the charge completion is detected, and the flow proceeds to Step S21.
(e) In Step S21 illustrated in Fig. 12, the reference-charge-period determining-circuit 522ᵢ₂ determines whether or not the charging-start-flag on the software program of the priority-determining circuit 523ᵢ is put up. If the charging-start-flag is not put up, the flow proceeds to Step S31 illustrated in Fig. 13. If the reference-charge-period determining-circuit 522ᵢ₂ determines that the charging-start-flag of the priority-determining circuit 523ᵢ is put up in Step S21, the flow proceeds to Step S22.
(f) In Step S22, whether the reference-charge-period determining-circuit 522ᵢ₂ has entered the charging-completion signal or not is determined. If the charging-completion signal has been fed, the flow proceeds to Step S23, the reference-charge-period determining-circuit 522ᵢ₂ transfers the count up signal to the priority-determining circuit 523ᵢ and advances the counter on the software program of the priority-determining circuit 523ᵢ by one, and the flow proceeds to Step S25. If the reference-charge-period determining-circuit 522ᵢ₂ has not transferred the charging-completion signal is determined in Step S22, the flow proceeds to Step S24. The reference-charge-period determining-circuit 522ᵢ₂ transfers the counter-reset signal to the priority-determining circuit 523ᵢ and resets the counter on the software program of the priority-determining circuit 523ᵢ, and then, the flow proceeds to Step S25.
(g) In Step S25, whether the reference-charge-period determining-circuit 522ᵢ₁ has entered the charging-completion signal or not is determined. If the charging-completion signal has been fed, the flow proceeds to Step S26, the reference-charge-period determining-circuit 522ᵢ₁ transfers the count up signal to the priority-determining circuit 523ᵢ and advances the counter on the software program of the priority-determining circuit 523ᵢ by one, and the flow proceeds to Step S28. If the reference-charge-period determining-circuit 522ᵢ₁ has not transferred the charging-completion signal is determined in Step S25, the flow proceeds to Step S27. The reference-charge-period determining-circuit 522ᵢ₁ transfers the counter-reset signal to the priority-determining circuit 523ᵢ and resets the counter on the software program of the priority-determining circuit 523ᵢ, and then, the flow proceeds to Step S28.
(h) In Step S28, whether the reference-charge-period determining-circuit 522ᵢ₃ has entered the charging-completion signal or not is determined. If the charging-completion signal has been fed, the flow proceeds to Step S29, the reference-charge-period determining-circuit 522ᵢ₃ transfers the count up signal to the priority-determining circuit 523ᵢ and advances the counter on the software program of the priority-determining circuit 523ᵢ by one, and the flow proceeds to Step S31 illustrated in Fig. 13. If the reference-charge-period determining-circuit 522ᵢ₃ has not transferred the charging-completion signal is determined in Step S28, the flow proceeds to Step S20. The reference-charge-period determining-circuit 522ᵢ₃ transfers the counter-reset signal to the priority-determining circuit 523ᵢ and resets the counter on the software program of the priority-determining circuit 523ᵢ, and then, the flow proceeds to Step S31. As mentioned above, in Step S21 illustrated in Fig. 12, when the charging-start-flag is detected, the charge completion is monitored in Steps S22, S25, and S28, and the counters 1, 2, and 3 are increased at timing when the charge completion is detected, and the flow proceeds to Step S31.
(i) In Step S31 illustrated in Fig. 13, the reference-charge-period determining-circuit 522ᵢ₃ determines whether or not the charging-start-flag on the software program of the priority-determining circuit 523ᵢ is put up. If the charging-start-flag is not put up, the flow proceeds to Step S41 illustrated in Fig. 14. If the reference-charge-period determining-circuit 522ᵢ₃ determines that the charging-start-flag of the priority-determining circuit 523ᵢ is put up in Step S31, the flow proceeds to Step S32.
(j) In Step S32, whether the reference-charge-period determining-circuit 522ᵢ₃ has entered the charging-completion signal or not is determined. If the charging-completion signal has been fed, the flow proceeds to Step S33, the reference-charge-period determining-circuit 522ᵢ₃ transfers the count up signal to the priority-determining circuit 523ᵢ and advances the counter on the software program of the priority-determining circuit 523ᵢ by one, and the flow proceeds to Step S35. If the reference-charge-period determining-circuit 522ᵢ₃ has not transferred the charging-completion signal is determined in Step S32, the flow proceeds to Step S34. The reference-charge-period determining-circuit 522ᵢ₃ transfers the counter-reset signal to the priority-determining circuit 523ᵢ and resets the counter on the software program of the priority-determining circuit 523ᵢ, and then, the flow proceeds to Step S35.
(k) In Step S35, whether the reference-charge-period determining-circuit 522ᵢ₁ has entered the charging-completion signal or not is determined. If the charging-completion signal has been fed, the flow proceeds to Step S36, the reference-charge-period determining-circuit 522ᵢ₁ transfers the count up signal to the priority-determining circuit 523ᵢ and advances the counter on the software program of the priority-determining circuit 523i by one, and the flow proceeds to Step S38. If the reference-charge-period determining-circuit 522ᵢ₁ has not transferred the charging-completion signal is determined in Step S35, the flow proceeds to Step S37. The reference-charge-period determining-circuit 522ᵢ₁ transfers the counter-reset signal to the priority-determining circuit 523ᵢ and resets the counter on the software program of the priority-determining circuit 523ᵢ, and then, the flow proceeds to Step S38.
(l) In Step S38, whether the reference-charge-period determining-circuit 522ᵢ₂ has entered the charging-completion signal or not is determined. If the charging-completion signal has been fed, the flow proceeds to Step S39, the reference-charge-period determining-circuit 522ᵢ₂ transfers the count up signal to the priority-determining circuit 523ᵢ and advances the counter on the software program of the priority-determining circuit 523ᵢ by one, and the flow proceeds to Step S41 illustrated in Fig. 14. If the reference-charge-period determining-circuit 522ᵢ₂ has not transferred the charging-completion signal is determined in Step S38, the flow proceeds to Step S30. The reference-charge-period determining-circuit 522ᵢ₂ transfers the counter-reset signal to the priority-determining circuit 523ᵢ and resets the counter on the software program of the priority-determining circuit 523ᵢ, and then, the flow proceeds to Step S41. As mentioned above, in Step S31 illustrated in Fig. 13, when the charging-start-flag is detected, the charge completion is monitored in Steps S32, S35, and S38, and the counters 1, 2, and 3 are increased at timing when the charge completion is detected, and the flow proceeds to Step S41.
(m) In Step S41 illustrated in Fig. 14, the priority-determining circuit 523i declares the confirmation of the priority order of the reference-charge-period determining-circuit 522ᵢ₁, and then, the flow proceeds to Step S42. In Step S41, since the number of the reference-charge-period determining-circuits 522ᵢ₁, 522ᵢ₂, 522ᵢ₃, ...... is large, priority order is to be confirmed for preventing from any missing of the priority checking, and for selecting a canonical counter for comparison, one of the reference-charge-period determining-circuits 522ᵢ₂, 522ᵢ₃, ......, of which the priority order is to be confirmed, is declared on the software program. In Step S42, the priority-determining circuit 523ᵢ determines whether the counter 1 of the reference-charge-period determining-circuit 522ᵢ₁ has advanced more than the counter 2 of the reference-charge-period determining-circuit 522ᵢ₂. If the counter 1 of the reference-charge-period determining-circuit 522ᵢ₁ has advanced more than the counter 2 of the reference-charge-period determining-circuit 522ᵢ₂, the flow proceeds to Step S43, and the priority-determining circuit 523ᵢ further determines whether the counter 1 of the reference-charge-period determining-circuit 522ᵢ₁ has advanced more than the counter 3 of the reference-charge-period determining-circuit 522ᵢ₃. If the priority-determining circuit 523ᵢ determines that the counter 1 of the reference-charge-period determining-circuit 522ᵢ₁ is not advanced more than the counter 2 of the reference-charge-period determining-circuit 522ᵢ₂ in Step S42, the flow proceeds to Step S44, and the priority display-lamp 544ᵢ₁ of the reference-charge-period determining-circuit 522ᵢ₁ is turned off, and the flow proceeds to Step S51 illustrated in Fig. 15.
(n) In Step S43, when the priority-determining circuit 523ᵢ determines that the counter 1 of the reference-charge-period determining-circuit 522ᵢ₁ has advanced more than the counter 3 of the reference-charge-period determining-circuit 522ᵢ₃, the flow proceeds to Step S45, and the priority display-lamp 544ᵢ₁ corresponding to the reference-charge-period determining-circuit 522ᵢ₁ is turned on. If the priority-determining circuit 523ᵢ determines that the counter 1 of the reference-charge-period determining-circuit 522ᵢ₁ has not advanced more than the counter 3 of the reference-charge-period determining-circuit 522ᵢ₃ in Step S43, the flow proceeds to Step S46, the priority display-lamp 544ᵢ₁ of the reference-charge-period determining-circuit 522ᵢ₁ is turned off, and the flow proceeds to Step S51 illustrated in Fig. 15.
(o) In Step S51 illustrated in Fig. 15, the priority-determining circuit 523ᵢ declares the confirmation of the priority order of the reference-charge-period determining-circuit 522ᵢ₂, and then, the flow proceeds to Step S52. In Step S51, as well as the case of Step S41, since the number of the reference-charge-period determining-circuits 522ᵢ₁, 522ᵢ₂, 522ᵢ₃, ....., is large, priority order is to be confirmed for preventing from any missing in the priority checking, and for selecting the canonical counter for comparison, one of the reference-charge-period determining-circuits 522ᵢ₂, 522ᵢ₃, ......, of which the priority order is to be confirmed, is declared on the software program. In Step S52, the priority-determining circuit 523ᵢ determines whether the counter 2 of the reference-charge-period determining-circuit 522ᵢ₂ has advanced more than the counter 1 of the reference-charge-period determining-circuit 522ᵢ₁. If the counter 2 of the reference-charge-period determining-circuit 522ᵢ₂ has advanced more than the counter 1 of the reference-charge-period determining-circuit 522ᵢ₁, the flow proceeds to Step S53, and the priority-determining circuit 523ᵢ further determines whether the counter 2 of the reference-charge-period determining-circuit 522ᵢ₂ has advanced more than the counter 3 of the reference-charge-period determining-circuit 522ᵢ₃. In Step S52, when the priority-determining circuit 523ᵢ determines that the counter 2 of the reference-charge-period determining-circuit 522ᵢ₂ is not advanced more than the counter 1 of the reference-charge-period determining-circuit 522ᵢ₁, the flow proceeds to Step S54. Then, the priority display-lamp 544ᵢ₂ of the reference-charge-period determining-circuit 522ᵢ₂ is turned off, and the flow proceeds to Step S61 illustrated in Fig. 16.
(p) In Step S53, when the priority-determining circuit 523ᵢ determines that the counter 2 of the reference-charge-period determining-circuit 522ᵢ₂ has advanced more than the counter 3 of the reference-charge-period determining-circuit 522ᵢ₃, the flow proceeds to Step S55, and the priority display-lamp 544ᵢ₂ corresponding to the reference-charge-period determining-circuit 522ᵢ₂ is turned on. When the priority-determining circuit 523ᵢ determines that the counter 2 of the reference-charge-period determining-circuit 522ᵢ₂ has not advanced more than the counter 3 of the reference-charge-period determining-circuit 522ᵢ₃ in Step S53, the flow proceeds to Step S56. Then, the priority display-lamp 544ᵢ₂ of the reference-charge-period determining-circuit 522ᵢ₂ is turned off, and the flow proceeds to Step S61 illustrated in Fig. 16.
(q) In Step S61 illustrated in Fig. 16, the priority-determining circuit 523ᵢ declares the confirmation of the priority order of the reference-charge-period determining-circuit 522ᵢ₃, and then, the flow proceeds to Step S62. In Step S61, similar to Steps S41 and S51, since the number of the reference-charge-period determining-circuits 522ᵢ₁, 522ᵢ₂, 522ᵢ₃, ...... is large, priority order is to be confirmed for preventing from any missing in the priority checking, and for selecting the canonical counter for comparison, one of the reference-charge-period determining-circuits 522ᵢ₂, 522ᵢ₃, ......, of which the priority order is to be confirmed, is declared on the software program. In Step S62, the priority-determining circuit 523ᵢ determines whether the counter 3 of the reference-charge-period determining-circuit 522ᵢ₃ has advanced more than the counter 1 of the reference-charge-period determining-circuit 522ᵢ₁. If the counter 3 of the reference-charge-period determining-circuit 522ᵢ₃ has advanced more than the counter 1 of the reference-charge-period determining-circuit 522ᵢ₁, the flow proceeds to Step S63, and the priority-determining circuit 523ᵢ further determines whether the counter 3 of the reference-charge-period determining-circuit 522ᵢ₃ has advanced more than the counter 2 of the reference-charge-period determining-circuit 522ᵢ₂. If the priority-determining circuit 523ᵢ determines that the counter 3 of the reference-charge-period determining-circuit 522ᵢ₃ is not advanced more than the counter 1 of the reference-charge-period determining-circuit 522ᵢ₁ in Step S62, the flow proceeds to Step S64. Then, the priority display-lamp 544ᵢ₃ of the reference-charge-period determining-circuit 522ᵢ₃ is turned off, and a series of the processes completes.
(r) In Step S63, when the priority-determining circuit 523i determines that the counter 3 of the reference-charge-period determining-circuit 522ᵢ₃ has advanced more than the counter 2 of the reference-charge-period determining-circuit 522ᵢ₂, the flow proceeds to Step S65, and the priority display-lamp 544ᵢ₃ corresponding to the reference-charge-period determining-circuit 522ᵢ₃ is turned on. If the priority-determining circuit 523ᵢ determines that the counter 3 of the reference-charge-period determining-circuit 522ᵢ₃ has not advanced more than the counter 2 of the reference-charge-period determining-circuit 522ᵢ₂ in Step S63, the flow proceeds to Step S66. Then, the priority display-lamp 544ᵢ₃ of the reference-charge-period determining-circuit 522ᵢ₃ is turned off, a series of the processes required for the priority checking completes, and the operation sequence is returned to Step S11 illustrated in Fig. 11.

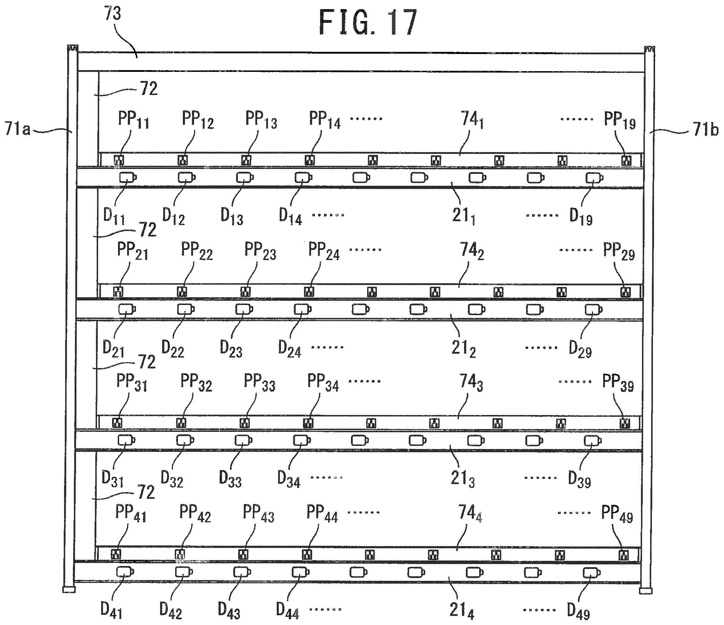

In the flowcharts illustrated in Figs. 14 to 16, although a case where three reference-charge-period determining-circuits including the reference-charge-period determining-circuits 522ᵢ₁, 522ᵢ₂, and 522ᵢ₃ are present has been described for the convenience of the description, when four or more reference-charge-period determining-circuits are present, after Step S43 illustrated in Fig. 14, a comparing process using the counter 1 as the reference is further continued. Furthermore, after Step S53 illustrated in Fig. 15, a comparing process using the counter 2 as the reference is continued. And, after Step S63 illustrated in Fig. 17, a comparing process using the counter 3 as the reference is further continued. In addition, after Steps S64, S65, and S66 illustrated in Fig. 16, a series of processes using the other counters such as a counter 4 as the reference, similar to the flowcharts illustrated in Figs. 14 to 16, is continued.

As mentioned above, according to the operation scheme of the charging system according to the first embodiment of the present invention, the simultaneous charging and the simultaneous housing of the multiple charge-scheduled devices IUC₁ₐ, IUC₂ₐ, ..., IUC₅ₐ; IUC_{1b}, IUC_{2b}, ..., IUC_{5b} are possible. In addition, because the charge-scheduled devices IUCia, IUC₂ₐ, ..., IUC₅ₐ; IUC_{1b}, IUC_{2b}, ..., IUC_{5b} which are fully charged are automatically blocked from electrical conduction, the over-charging of rechargeable batteries can be prevented. In addition, due to the arrangement of the display portions D₁ₐ, D₂ₐ, ..., D₅ₐ; D_{1b}, D_{2b}, ..., D_{5b} on the surface of the display panel 21 of the tower, in which a plurality of the charge-scheduled devices IUC₁ₐ, IUC₂ₐ, ..., IUC₅ₐ; IUC_{1b}, IUC_{2b}, ..., IUC_{5b} are mounted, by blinking the priority display-lamp 544ᵢ₂ so as to show that the charging of the charge-scheduled devices IUC₁ₐ, IUC₂ₐ, ..., IUC₅ₐ; IUC_{1b}, IUC_{2b}, ..., IUC_{5b} has been completed, the use order of the charge-scheduled devices IUC₁ₐ, IUC₂ₐ, ..., IUC₅ₐ; IUC_{1b}, IUC_{2b}, ..., IUC_{5b} in the first-in first-out scheme can be clarified.

Therefore, according to the charging system of the first embodiment, it is possible to perform the maintenance and to build the operating system of rechargeable batteries, which are smooth and safe. And therefore, it is possible to achieve the effective management of the charging of rechargeable batteries, preventing the over-charging and the over-discharging.

### (SECOND EMBODIMENT)

As illustrated by a front view in Fig. 17, a charging system according to a second embodiment of the present invention is built up from racks (71a, 71b, 72, 73, 21₁, 21₂, 21₃, and 21₄) instead of the tower (21, 22, 23a, 23b, 23c, 23d, and 29) described in the first embodiment. In other words, the racks (71a, 71b, 72, 73, 21₁, 21₂, 21₃, and 21₄) implementing a frame of the charging system according to the second embodiment includes a plurality of shelves 21ᵢ (=21₁, 21₂, 21₃, and 21₄), horizontal boards 71a and 71b that support the plurality of shelves 21₁, 21₂, 21₃, and 21₄, and a top board 73 that connects the upper end portions of the horizontal boards 71a and 71b. In addition, a power-breaker installation-case 72 that is a box of a vertically-long rectangular parallelepiped is arranged in the vertical direction along a rear end portion of the left horizontal board 71a. In Fig. 17, the power-breaker installation-case 72 located at the rear side is intermittently exposed at a left end between the top board 73 and the shelf 21₁ of the first tier, a left end between the shelf 21₁ of the first tier and the shelf 21₂ of the second tier, a left end between the shelf 21₂ of the second tier and the shelf 21₃ of the third tier, and a left end between the shelf 21₃ of the third tier and the shelf 21₄ of the fourth tier, respectively.

Furthermore, along rear edges of the plurality of shelves 21₁, 21₂, 21₃, and 21₄, power-feeder installation-boxes 741, 74₂, 74₃, and 74₄, which are boxes of horizontally-long rectangular parallelepipeds, are horizontally disposed to be brought into contact with top surfaces of the plurality of shelves 21₁, 21₂, 21₃, and 21₄. In the power-feeder installation-box 741 disposed horizontally along the rear edge of the shelf 21₁ of the uppermost tier, or the first tier, a plurality of power-feeding units PP₁₁, PP₁₂, ......, and PP₁₉ are arranged. Similarly, in the power-feeder installation-box 74₂ disposed horizontally along the rear edge of the shelf 21₂ of the second tier, a plurality of power-feeding units PP₂₁, PP₂₂, ....... and PP₂₉ are arranged. Similarly, in the power-feeder installation-box 74₃ disposed horizontally along the rear edge of the shelf 21₃ of the third tier, a plurality of power-feeding units PP₃₁, PP₃₂, ......., and PP₃₉ are arranged, and, in the power-feeder installation-box 741 disposed horizontally along the rear edge of the shelf 21₁ of the lowermost tier, or the fourth tier, a plurality of power-feeding units PP₁₁, PP₁₂, ......, and PP₁₉ are arranged. In the charging system according to the second embodiment, a plurality of power-feeding units PPᵢ₁, PPᵢ₂, ......, and PPᵢⱼ (i=1 to 4; j=1 to 9) are arranged in the horizontal direction of the plurality of shelves 21₁, 21₂, 21₃, and 21₄ of the racks having the plurality of shelves 21₁, 21₂, 21₃, and 21₄.

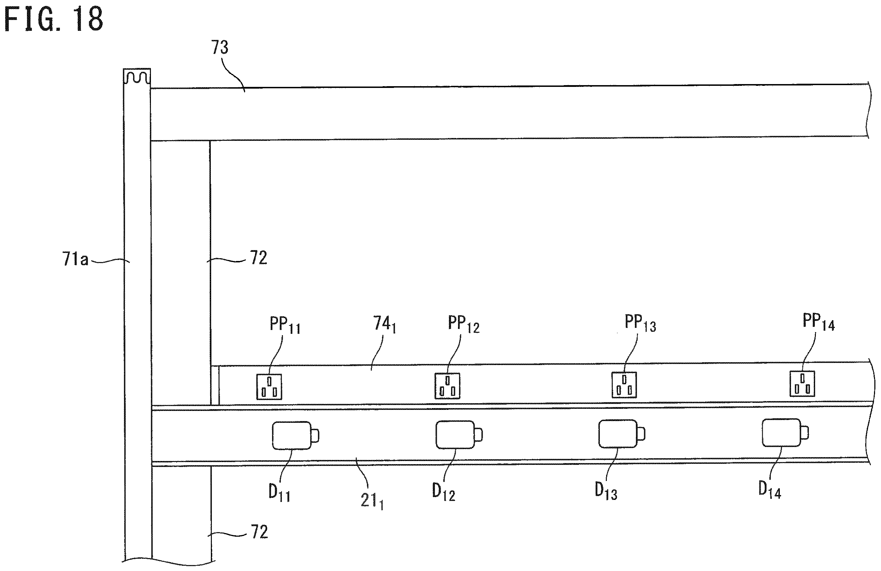

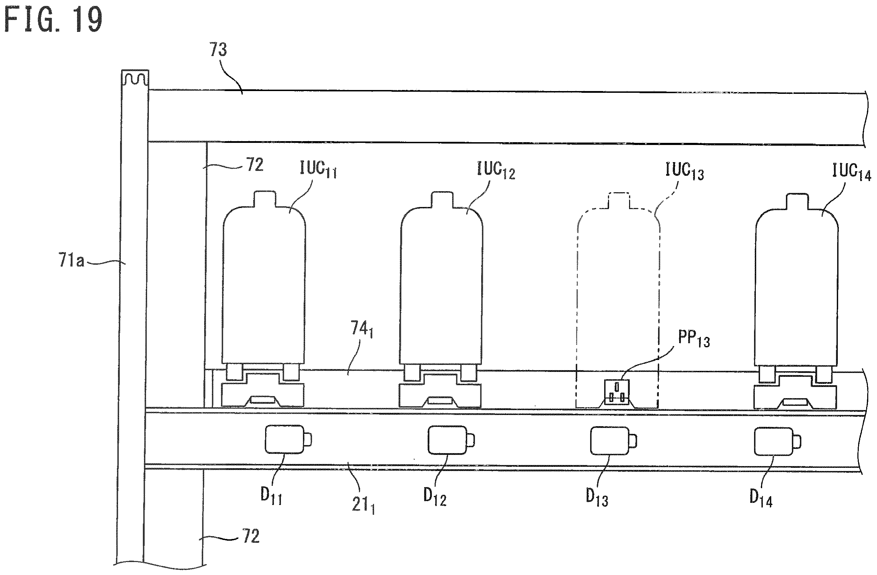

As illustrated in Fig. 18 of an enlarged view, in the power-feeder installation-box 741 of the shelf 21₁ of the first tier, a plurality of power-feeding units PP₁₁, PP₁₂, PP₁₃, PP₁₄, ...... are arranged. As an example, corresponding to the configuration illustrated in Fig. 18, on the shelf 21₁ of the first tier, a plurality of charge-scheduled devices IUC₁₁, IUC₁₂, IUC₁₃, IUC₁₄, ... are mounted to be connectable to the plurality of power-feeding units PP₁₁, PP₁₂, PP₁₃, PP₁₄, ....... as illustrated in Fig. 19. In the example illustrated in Fig. 19, since the charge-scheduled device IUC₁₃, which is scheduled to be arranged at third space from the left side is not mounted, a state in which only the power-feeding unit PP₁₃ disposed at the rear edge of the shelf 21₁ is viewed. As a matter of course, the power-feeding unit PP₁₁ is arranged at the rear side of the charge-scheduled device IUC₁₁ assigned at a left end space, the power-feeding unit PP₁₂ is arranged at the rear side of the charge-scheduled device IUC₁₂ assigned at second space from the left side, and the power-feeding unit PP₁₄ is arranged at the rear side of the charge-scheduled device IUC₁₄ assigned at fourth space from the left side.

Similar to the configuration illustrated in Fig. 5, the charging system according to the second embodiment includes charge-end-point detecting-circuits 521ᵢ₁, 521ᵢ₂, 521ᵢ₃, ...... that independently measure changes of a plurality of currents supplied respectively from commercial power to a plurality of charge-scheduled devices IUCᵢ₁, IUCᵢ₂, ......, and IUCᵢⱼ (i=1 to 4; j=1 to 9), which are charged through a plurality of power-feeding units PPᵢ₁, PPᵢ₂, ......, and PPᵢⱼ, so as to detect charging-start timings and charging-end timings for the plurality of charge-scheduled devices IUCᵢ₁, IUCᵢ₂, ......, and IUCᵢⱼ. The charging system further includes reference-charge-period determining-circuits 522ᵢ₁, 522ᵢ₂, 522ᵢ₃, ...... that receive information of the charging-start timings from the charge-end-point detecting-circuits 521ᵢ₁, 521ᵢ₂, 521ᵢ₃, ...... so as to measure reference-charge-periods, which are determined in advance, from the charging-start timings of the charge-scheduled devices IUCᵢ₁, IUCᵢ₂, ......, IUCᵢⱼ. The charging system still further includes a priority-determining circuit 523ᵢ that determines priority in the use order of a plurality of charge-scheduled devices IUCᵢ₁, IUCᵢ₂,......, IUCᵢⱼ based on the charging-periods of the charge-scheduled devices IUCᵢ₁, IUCᵢ₂,......, IUCᵢⱼ under a condition such that a plurality of the charge-scheduled devices IUCᵢ₁, IUCᵢ₂,......, IUCᵢⱼ including the charge-scheduled devices IUCᵢ₁, IUCᵢ₂,......, IUCᵢⱼ, each of which having completed the charging, are connected to a plurality of power-feeding units PPᵢ₁, PPᵢ₂, PPᵢⱼ, ....... And, the charging system yet still further includes charging-state display circuits 53ᵢ₁, 53ᵢ₂, 53ᵢ₃, ...... displaying "under-charging" or "charge-completed" of the plurality of charge-scheduled devices IUCᵢ₁, IUCᵢ₂, ......, and IUCᵢⱼ and priority in the use order of the plurality of charge-scheduled devices IUCᵢ₁, IUCᵢ₂, ....... and IUCᵢⱼ. Here, the contents and the operations of the charge-end-point detecting-circuits 521ᵢ₁, 521ᵢ₂, 521ᵢ₃, ......, the reference-charge-period determining-circuits 522ᵢ₁, 522ᵢ₂, 522ᵢ₃, ....... the priority-determining circuit 523i, and the charging-state displaying circuits 53ᵢ₁, 53ᵢ₂, 53ᵢ₃, ...... are the same as described for the charging system according to the first embodiment. However, Fig. 5 has illustrated a case where three reference-charge-period determining-circuits 522ᵢ₁, 522ᵢ₂, and 522ᵢ₃ are included as an example. Therefore, for the convenience of the description, in the charging system according to the first embodiment, the sequence of procedure has been described as follows:
in Steps S12, S15, and S18 illustrated in Fig. 11, the charging-completion is detected, and the counters 1, 2, and 3 are increased,
in Steps S22, S25, and S28 illustrated in Fig. 12, the charging-completion is detected, and the counters 1, 2, and 3 are increased,
in Steps S32, S35, and S38 illustrated in Fig. 13, the charging-completion is detected, and the counters 1, 2, and 3 are increased, and thereafter,
the flow of the operation sequence proceeds to the priority order comparison in Step S41.

However, the structure illustrated in Fig. 17 may correspond equivalently to a configuration such that nine reference-charge-period determining-circuits 522ᵢ₁, 522ᵢ₂, 522ᵢ₃......., and 522ᵢⱼ (i=1 to 4; j=1 to 9) are arranged on the shelves 21₁, 21₂, 21₃, and 21₄ of four tiers in the charging system according to the second embodiment, for example. According to the representation of the flowcharts illustrated in Figs. 14 to 16, 'board 1' to 'board 9' are arranged on the shelves 21₁, 21₂, 21₃, and 21₄ of four tiers, respectively. Accordingly, inside the software program, counters 1 to 9 corresponding to nine circuits to be assigned to one tier are prepared, and the counters 1 to 9 wait for, respectively, the feed of the completion signals of the reference-charge-period determining-circuits 522ᵢ₁, 522ᵢ₂, 522ᵢ₃....... 522ᵢⱼ. Therefore, after Step S43 illustrated in Fig. 14, a comparing process using the counter 1 as the criterion is further continued up to the counter 9, successively, and, after Step S53 illustrated in Fig. 15, a comparing process using the counter 2 as the criterion is continued up to the counter 9, successively, and, after Step S63 illustrated in Fig. 17, a comparing process using the counter 3 as the criterion is continued up to the counter 9 successively. In addition, after steps S64, S65, and S66 illustrated in Fig. 16, a series of processes using the counter 4 to the counter 9 as the criterion similar to the flowcharts illustrated in Figs. 14 to 16 is further continued successively. And therefore, on/off-states of the completion signals and on/off-states of the completion signal flags of the counters 1 to 9 are checked, respectively. If any counter of which the completion signal flag is off-state exists, and the completion signal is on-state, the operation sequence enters a counter-up loop, and the numerical value of the counter corresponding to the completion signal is caused to advance by one, and the completion signal flag is turned on. At that time, the numerical value of the counter of which the completion signal flag is on-states advances by one. The counter of which the completion signal is off-state is reset, and after the completion signal flag is turned off, the operation sequence exits from the count-up loop. If the completion signal flag of the counter is on-state and the completion signal is on-state, the operation sequence of the counter skips the count-up loop. If the completion signal and the completion signal flag turn on once, the completion signal and the completion signal flag become a waiting state so as to maintain the on-state, and the waiting state continues until one of the corresponding charge-scheduled devices IUCᵢ₁, IUCᵢ₂, ......, IUCᵢⱼ is taken out from the shelves 21₁, 21₂, 21₃, and 21₄. Then, after the operation sequences at the shelves 21₁, 21₂, 21₃, and 21₄ are performed, the operation sequence is moved to a priority order comparing-operation loop for the shelves 21₁, 21₂, 21₃, and 21₄.

By classifying the priority-determining circuits 523i (i=1 to 4) into each of the shelves 21₁, 21₂, 21₃, and 21₄, respectively, four types of devices can be charged for each of the shelves 21₁, 21₂, 21₃, 21₄ such as a set of transfusion pumps on the shelf 21₁ of the first tier, a set of syringe pumps on the shelf 21₂ of the second tier, and the like. In the priority order comparing-operation loop in each of the shelves 21₁, 21₂, 21₃, and 21₄, the counter 1 is used as the criterion, the counter numerical values of the counters 2 to 9 are compared with the counter numerical values for all the combinations, and, when the numerical value of the reference counter is largest, a priority displaying signal is to one of the reference-charge-period determining-circuits 522ᵢ₁, 522ᵢ₂, 522ᵢ₃......, 522ᵢⱼ that corresponds to the reference counter is, and, when a counter numerical value is larger than the reference counter, the preferential displaying signal is not transmitted.

The reference counter can be changed from the counter 1 to the counter 9 at any time as needed, the priority-determining circuit 523i compares all the combinations with each of the counters, and the necessity of the output of the preferential displaying signal is determined. Any one of the reference-charge-period determining-circuits 522ᵢ₁, 522ᵢ₂, 522ᵢ₃......, 522ᵢⱼ to which the preferential displaying signal has been fed turns on the priority display-lamp of the indicator. Then, when the comparing processes and the determinations of necessity of the outputs of the preferential displaying signals for all of the counters 1 to 9 end, the operation sequence is returned to the operation loop of the counter numerical value. When any one of the charge-scheduled devices IUCᵢ₁, IUCᵢ₂, ......, IUCᵢⱼ of which the priority display-lamp is turned on is taken out, a completion signal is turned off, the counter numerical value is reset in the counter numerical-value-operation loop, and the priority signal display is turned off in the comparing-operation loop. Also if any circuit exists, which is interrupted before the feeding of a charging-completion signal, no influence on the priority-determining circuit 523i occurs. The other operation sequences are substantially the same as those of the charging system according to the first embodiment described above, therefore, duplicate description will not be presented.

In addition, on the top surface of each of the shelves 21₁, 21₂, 21₃, and 21₄ implementing the four tiers structure, a plurality of load-presence detecting sensors are arranged to be paired with the allocated position of each of the power-feeding units PPᵢ₁, PPᵢ₂, ......, PPᵢⱼ, although the plurality of load-presence detecting sensors are not illustrated. The load-presence detecting sensor is a sensor that detects whether or not the charge-scheduled devices IUCᵢ₁, IUCᵢ₂, ......, IUCᵢⱼ are present at target positions on the shelves 21₁, 21₂, 21₃, and 21₄ of the four tiers and, for example, may be a sensor that detects a fault state of an optical path by using a set of a light emitting device and a light receiving device. More specifically, infrared light is projected from a light emitting device to the charge-scheduled devices IUCᵢ₁, IUCᵢ₂, ......, IUCᵢⱼ in a pulse waveform, and a light emitting device receives the pulse of the infrared light, therefore, the sensor may be caused not to react to infrared light arriving due to an external disturbance.

Since the charging system according to the second embodiment includes the load-presence detecting sensor connected to the load-presence detecting circuit 51ᵢ, when both a load-presence detecting signal transmitted from the load-presence detecting circuit 51ᵢ and a current-detecting signal transmitted from corresponding one of the charge-end-point detecting-circuits 521ᵢ₁, 521ᵢ₂, 521ᵢ₃, ...... are fed, each of the reference-charge-period determining-circuits 522ᵢ₁, 522ᵢ₂, 522ᵢ₃...... 522ᵢⱼ counts a predetermined period -- for example, 15 hours-- and, after the end of the counting, transfers a completion signal to the priority-determining circuit 523ᵢ. When a state is continued for ten minutes in which the load-presence detecting signal is fed to the reference-charge-period determining-circuits 522ᵢ₁, 522ᵢ₂, 522ᵢ₃......, 522ᵢⱼ, and the current-detecting signal is not fed to the reference-charge-period determining-circuits 522ᵢ₁, 522ᵢ₂, 522ᵢ₃, 522ᵢⱼ, the counting of the predetermined period is skipped, and any one of the reference-charge-period determining-circuits 522ᵢ₁, 522ᵢ₂, 522ᵢ₃......, 522ᵢⱼ corresponding to the reference-charge-period determining-circuits in which the counting of the predetermined period is skipped transfers a charging-completion signal. If the feed of the load-presence detecting signal disappears during the counting process of the predetermined period, a warning against taking-out can be informed by blinking the under-charging-state display-lamp.

In addition, as illustrated in Fig. 17, at the front end portion of each of the shelves 21₁, 21₂, 21₃, and 21₄ implementing the four tiers structure, the display portions D₁₁, D₁₂, ......, Dᵢⱼ (i=1 to 4; j=1 to 9), which display respectively the under-charging information, the charge-completed information, and the priority order after receiving the signals from the charging-state displaying circuits 53ᵢ₁, 53ᵢ₂, 53ᵢ₃, ......, 53ᵢⱼ (i=1 to 4; j=1 to 9), are arranged respectively to be paired with the plurality of power-feeding units PPᵢ₁, PPᵢ₂, ......, PPᵢⱼ.

According to the charging system of the second embodiment, the load-presence detecting circuit 51ᵢ and the reference-charge-period determining-circuits 522ᵢ₁, 522ᵢ₂, 522ᵢ₃, ....... 522ᵢⱼ are included, therefore, the procedure of turning the switch on at the start of charging and the procedure of turning off the switch when the device taking out is unnecessary. In addition, the switch is not turned on when the charge-scheduled device IUCᵢⱼ is not connected, and no fault at the time of determining the priority order exists.

In addition, according to the charging system of the second embodiment, a charging system can be provided which is capable of simultaneously housing and charging a maximum of 36 charge-scheduled devices IUCᵢ₁, IUCᵢ₂, ......, IUCᵢⱼ (i=1 to 4; j=1 to 9). And the charging system of the second embodiment can individually manage the plurality of charge-scheduled devices IUCᵢ₁, IUCᵢ₂, ......, IUCᵢⱼ, the individual management may include the degradation of rechargeable batteries, by accurately monitoring the charged statuses of the plurality of charge-scheduled devices IUCᵢ₁, IUCᵢ₂, ......, IUCᵢⱼ and by preventing imbalances in the use-frequencies of the plurality of charge-scheduled devices IUCᵢ₁, IUCᵢ₂, ......, IUCᵢⱼ ascribable to the differences in the charging-period.

According to the charging system of the second embodiment, because the electric conduction of the charge-scheduled devices IUCᵢ₁, IUCᵢ₂, ......, IUCᵢⱼ that are fully charged is blocked without plugging in/out a power plug, the over-charge of rechargeable batteries can be prevented. In addition, because the display portions D₁₁, D₁₂, ......, Dᵢⱼ (i=1 to 4; j=1 to 9) are arranged respectively at front end portions of the shelves 21₁, 21₂, 21₃, and 21₄ of the tiers, on which the charge-scheduled devices IUCᵢ₁, IUCᵢ₂, ......, IUCᵢⱼ are mounted, by blinking the priority display-lamps when the charging has been completed, the use priority orders in a scheme of first-in first-out can be clarified.

Therefore, according to the charging system of the second embodiment, an efficient management of charging of rechargeable batteries can be achieved by building up the maintenance and operating system for rechargeable batteries, which is smooth and safe, preventing the over-charging and the over-discharging.

### (THIRD EMBODIMENT)

In the charging systems according to the first and second embodiments, when both the "load-presence detecting signal" and the "current-detecting signal" are fed, the predetermined period -- for example, 15 hours-- is counted, and, when a state in which the "current-detecting signal" is not fed is continued for a predetermined time -- for example, ten minutes--, the counting of the predetermined period is skipped, and a "charging-completion signal" is transmitted to the priority-determining circuit. Then, based on the order in which the respective "charging-completion signals" are entered, the priority in the use order of a plurality of charge-scheduled devices are determined. However, in a charging system according to a third embodiment of the present invention, the charging-state of each charge-scheduled device can be individually determined, and the priority in the use order of charge-scheduled devices can be determined without counting the predetermined period and without causing a state in which the current-detecting signal is not fed is continued for a predetermined time.

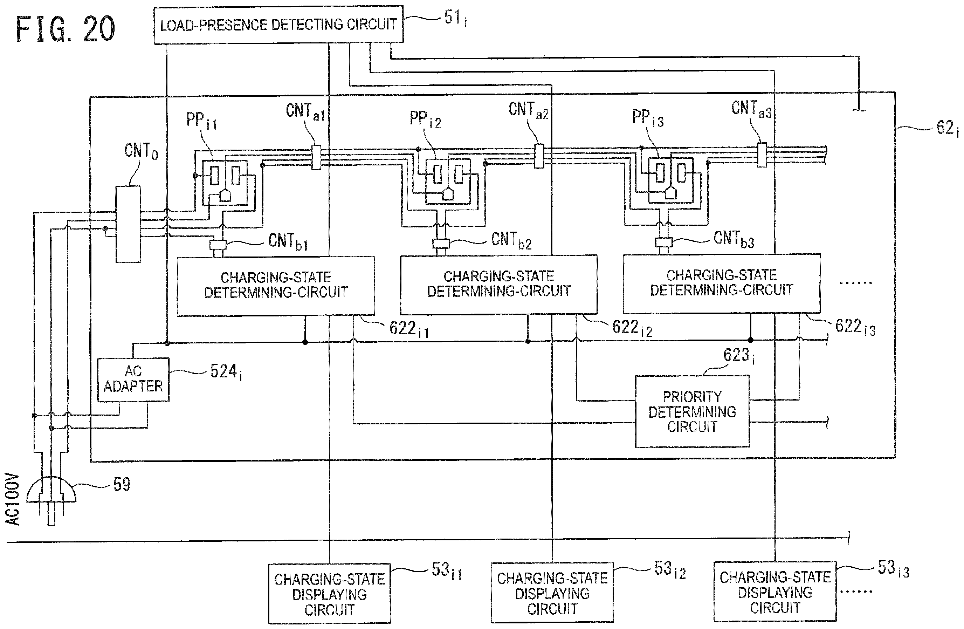

A charging-state managing circuit 62ᵢ of the charging system according to the third embodiment, as illustrated in a block diagram of Fig. 20, includes a plurality of charging-state determining-circuits 622ᵢ₁, 622ᵢ₂, 622ᵢ₃, ......, which independently measure the changes of currents supplied from commercial power to a plurality of charge-scheduled devices that are charged from a plurality of power-feeding units PPᵢ₁, PPᵢ₂, PPᵢ₃, ...... so as to determine the charging-state of each of the charge-scheduled devices. The charging system according to the third embodiment further includes a priority-determining circuit 623ᵢ that determines priority in the use order of the plurality of the charge-scheduled devices, based on the charging-state of each of the charge-scheduled devices, under a condition such that the plurality of charge-scheduled devices, including the charge-scheduled devices of which charging has completed, are connected to the plurality of power-feeding units PPᵢ₁, PPᵢ₂, PPᵢ₃, ....... The charging-state managing circuit 62ᵢ implementing the charging system according to the third embodiment is connected to a plurality of charging-state displaying circuits 53ᵢ₁, 53ᵢ₂, 53ᵢ₃, ...... that display whether each of the plurality of charge-scheduled devices is in the "under-charging" or the "charge-completed" state, and further display the priority order in the plurality of charge-scheduled devices.

In the charging system according to the third embodiment, configurations other than the charging-state determining-circuits 622ᵢ₁, 622ᵢ₂, 622ᵢ₃, ...... and the priority-determining circuit 623ᵢ are substantially the same as the constituent elements of the first and second embodiments having the same names, therefore, hereinafter, duplicate description will not be presented, and, mainly, the charging-state determining-circuits 622ᵢ₁, 622ᵢ₂, 622ᵢ₃, ...... and the priority-determining circuit 623ᵢ will be described.

As illustrated in a block diagram of Fig. 20, the charging-state determining-circuits 622ᵢ₁, 622ᵢ₂, 622ᵢ₃, ...... are connected to the priority-determining circuit 623ᵢ, the charging-state determining-circuit 622ᵢ₁ is connected to the charging-state displaying circuit 53ᵢ₁, the charging-state determining-circuit 622ᵢ₂ is connected to the charging-state displaying circuit 53ᵢ₂, and the charging-state determining-circuit 622ᵢ₃ is connected to the charging-state displaying circuit 53ᵢ₃. The charging-state managing circuit 62ᵢ is further connected to a load-presence detecting circuit 51ᵢ, and the output of the load-presence detecting circuit 51ᵢ is distributed to the corresponding charging-state determining-circuits 622ᵢ₁, 622ᵢ₂, 622ᵢ₃, ...... installed in the charging-state managing circuit 62ᵢ.

In addition, each of the charging-state determining-circuits 622ᵢ₁, 622ᵢ₂, 622ᵢ₃...... is connected to charging cord, although the electric cord for charge is not illustrated. The charging cord are wirings branched from the middle of a power-feed cord 31ᵢⱼ toward one of the charge-scheduled devices that is, for example, attached to a pole prepared for transfusion instrument. And the charging cord can be attached through a distributor or the like. Each of the charging-current signals is fed through the charging cord.

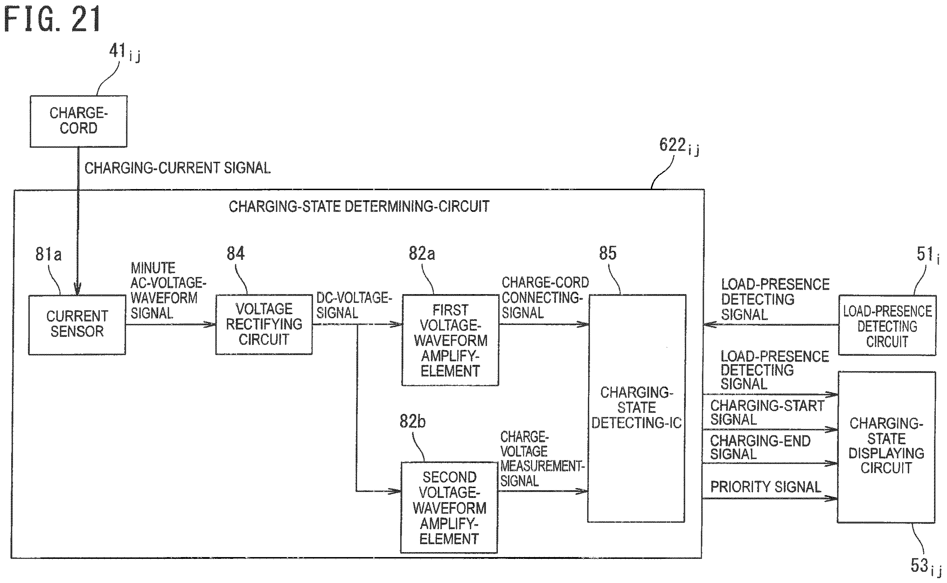

The charging-state determining-circuit 622ᵢⱼ, as illustrated in a block diagram of Fig. 21, includes a current sensor 81a to which a charging-current signal is fed from the charge-cord 41ᵢⱼ, a voltage rectifying circuit 84 that is connected to a later stage of the current sensor 81a, and a first voltage-waveform amplify-element 82a and a second voltage-waveform amplify-element 82b that are connected in parallel to a later stage of the voltage rectifying circuit 84. In addition, the charging-state determining-circuit 622ᵢⱼ includes a charging-state detecting-IC 85 that is simultaneously connected to both the first voltage-waveform amplify-element 82a and the second voltage-waveform amplify-element 82b in a later stage of the first voltage-waveform amplify-element 82a and the second voltage-waveform amplify-element 82b.

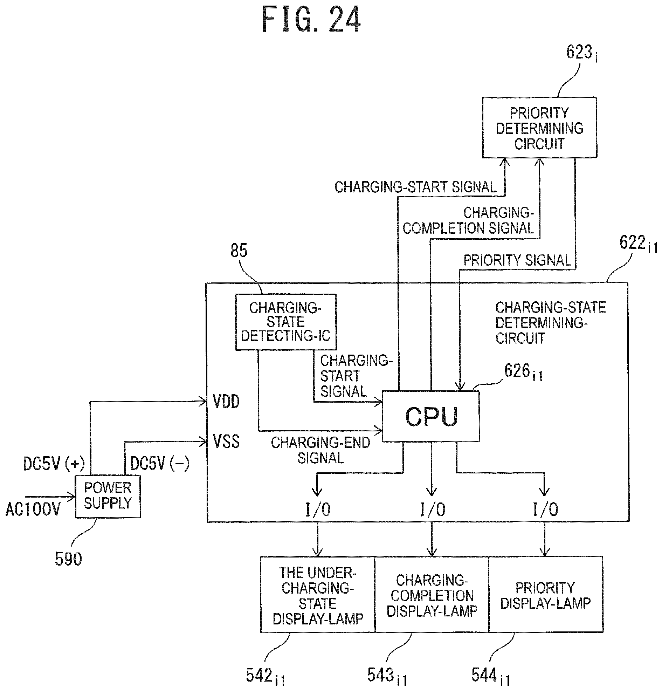

Furthermore, the charging-state determining-circuit 622ᵢⱼ includes a microprocessor (CPU) connected to the charging-state detecting-IC 85. The microprocessor (CPU) is represented as a CPU 626ᵢ₁ in a block diagram of Fig. 24 as an example. The charging-state determining-circuit 622ᵢⱼ, as illustrated in Fig. 21, transfers a charging-start signal, a charging-end signal, and a priority signal to a charging-state displaying circuit 53ᵢⱼ through the CPU. In addition, a load-presence detecting signal is fed to the charging-state determining-circuit 622ᵢⱼ from the load-presence detecting circuit 51ᵢ through the CPU, and the charging-state determining-circuit 622ᵢⱼ transfers a load-presence detecting signal to the charging-state displaying circuit 53ᵢⱼ through the CPU.

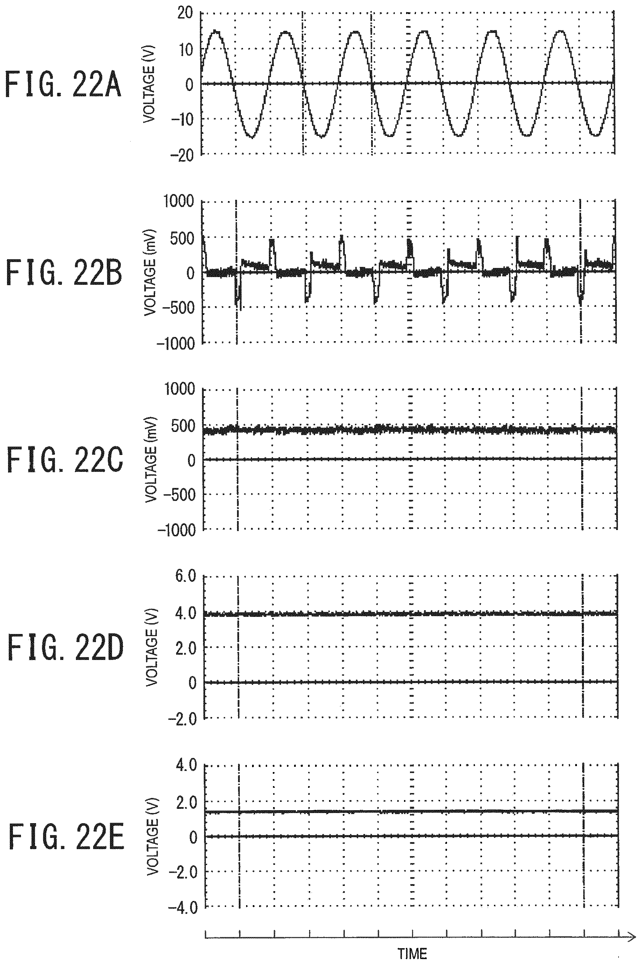

In the middle-of-charging of one of the charge-scheduled devices, as illustrated in a waveform diagram of Fig. 22A, a charging-current signal is fed through the charging cable to the current sensor 81a time-dependently. In Fig. 22A, a charging-current signal of a sinusoidal wave having positive and negative peak-widths of about 15 V is illustrated as an example. When a charging-current signal is detected, the current sensor 81a a minute AC voltage-waveform signal from the entered charging-current signal and transfers the minute AC voltage-waveform signal. In a waveform diagram of Fig. 22B, as the minute AC voltage-waveform signal, a waveform approximated to a spike pattern having a positive peak value of about 500 mV responding to the input of a maximum value 15 volts of the sinusoidal wave illustrated in Fig. 22A and a negative peak value of about -500 mV responding to the input of a minimum value -15 volts of the sinusoidal wave is illustrated an example. In other words, the current sensor 81a transfers a rising detection waveform that corresponds to only the maximum value and the minimum value of the charging-current signal. If the charge-cord 41ᵢⱼ is not connected to the power-feed cord 31ᵢⱼ, the charging-current signal is not fed, and the minute AC voltage-waveform signal does not appear.

The voltage rectifying circuit 84 inverts the negative-side waveform of the minute AC voltage-waveform signal to a positive-side waveform and smooths the obtained waveform, therefore, full-wave rectification of the entered minute AC voltage-waveform signal to a DC-voltage signal is performed and the DC-voltage signal is transmitted. In a waveform diagram of Fig. 22C, a waveform of a DC-voltage signal of about 400 mV, which is obtained by rectifying the minute AC voltage-waveform signal, being fed immediately after the start of charging, is illustrated as an example. The DC-voltage signal is fed to the first voltage-waveform amplify-element 82a and the second voltage-waveform amplify-element 82b from the voltage rectifying circuit 84.

The first voltage-waveform amplify-element 82a amplifies the entered DC-voltage signal and continuously transfers a resultant signal to the charging-state detecting-IC 85 as charge-cord connecting-signal. In a waveform diagram of Fig. 22D, a state in which a DC-voltage signal of about 400 mV is amplified to about 4.0 volts is illustrated as an example. The first voltage-waveform amplify-element 82a amplifies the DC-voltage signal such that a constant voltage can be transferred, regardless of the increase or the decrease of the DC-voltage signal supplied from the voltage rectifying circuit 84, unless the input of the DC-voltage signal is discontinued.

In other words, the amplification factor, or the gain of the first voltage-waveform amplify-element 82a is changed so as to continuously transmit a constant voltage until charging is completed from the start of the charging, and the magnitude of the charge-cord connecting-signal does not change even when the charging-state advances consequently. For example, as illustrated in Fig. 22D, a value of about 4.0 volts is maintained during the charging.

Then, after the charge-scheduled device is determined to be in the charge-completed state, the first voltage-waveform amplify-element 82a stops the operation of changing the amplification factor and maintains a constant amplification factor. In a waveform diagram of Fig. 22E, a state is illustrated as an example in which, after the charging is completed, the entered DC-voltage signal is amplified to charge-cord connecting-signal of about 1.5 volts with a constant amplification factor.

The second voltage-waveform amplify-element 82b amplifies an entered DC-voltage signal and transmit the resultant signal as a charge-voltage measurement-signal. The second voltage-waveform amplify-element 82b is set to maintain a constant amplification factor without changing the amplification factor in the middle of the charging. Accordingly, the magnitude of the charging-voltage-waveform signal transmitted from the second voltage-waveform amplify-element 82b is amplified and changed according to the magnitude of the entered DC-voltage signal. In other words, based on the magnitude of the charging-voltage-waveform signal transmitted from the second voltage-waveform amplify-element 82b, the increase or the decrease of the DC-voltage signal supplied from the voltage rectifying circuit 84 of the previous stage can be detected.

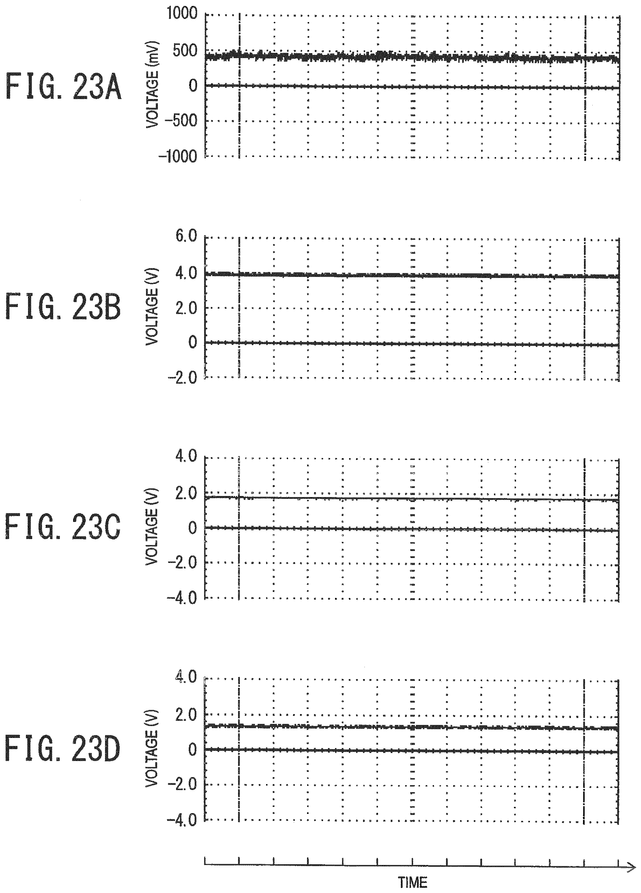

In a waveform diagram of Fig. 23A, the waveform of charge-cord connecting-signal rectified to about 400 mV as illustrated in Fig. 22C is illustrated, and, in a waveform diagram of Fig. 23B represented on the lower side, the waveform of a charge-voltage measurement-signal amplified by the second voltage-waveform amplify-element 82b immediately after the start of charging is illustrated as an example. As illustrated in Fig. 23B, the charge-voltage measurement-signal immediately after the start of charging manifests a DC waveform of a voltage --about 4.0 volts-- that is approximately the same as a voltage amplified by the first voltage-waveform amplify-element 82a illustrated in Fig. 22D. However, accompanying the advance of the charging, the charging-current signal supplied through the charge-cord 41ᵢⱼ gradually decreases, therefore, the charge-voltage measurement-signal gradually decreases in voltage in accordance with the elapse of time. In a waveform diagram of Fig. 23C, as the waveform of a charge-voltage measurement-signal immediately before the end of the charging, a waveform decreased from about 4.0 volts to about 1.8 volts is illustrated as an example.

In a waveform diagram of Fig. 23D, as a charge-voltage measurement-signal after the completion of charging, a waveform having a magnitude of about 1.5 volts is illustrated as an example. It can be understood that the waveform of the charge-voltage measurement-signal after the completion of the charging is approximately the same as the waveform of the charge-cord connecting-signal after the completion of the charging illustrated in Fig. 22E as an example. In other words, a constant amplification factor used by the second voltage-waveform amplify-element 82b is set to a value that is the same as the constant amplification factor used by the first voltage-waveform amplify-element 82a after the completion of the charging.

The first voltage-waveform amplify-element 82a and the second voltage-waveform amplify-element 82b are common in that supplied DC-voltage signals of the same magnitude are amplified. However, because the first and second voltage-waveform amplify-elements 82a and 82b have mutually-different target measurement ranges, mutually-different amplification factors are assigned to the DC-voltage signal at the time of charging.

The charge-cord connecting-signal and the charge-voltage measurement-signal are fed to the charging-state detecting-IC 85. When both the charge-cord connecting-signal and the charge-voltage measurement-signal are fed, the charging-state detecting-IC 85 determines that charging is started and transfers a charging-start signal to the CPU of the charging-state determining-circuit 622ᵢⱼ, and the CPU transmit the charging-start signal to the charging-state displaying circuit.

In addition, the charging-state detecting-IC 85 stores the magnitude of the charge-voltage measurement-signal at an initial time point fed simultaneously with the charge-cord connecting-signal as an "initial value" in a temporary memory, which is not illustrated, disposed in the charging-state determining-circuit. Thereafter, until the charging is completed, charge-voltage measurement-signals supplied from the second voltage-waveform amplify-element 82b are sequentially detected and stores the detected charge-voltage measurement-signal in the temporary memory as a "present value". The charging-state detecting-IC 85 determines whether a quotient obtained by dividing the present value by the initial value is equal to the threshold or less. If the quotient is larger than the threshold, and the process of comparing the present value and the initial value continues. In the process of the comparing, the present value is updated every time when the present value is obtained.

In addition, if the value of the charge-voltage measurement-signal is the threshold value or less, the charging-state detecting-IC 85 determines that the charging of the charge-scheduled device IUCᵢⱼ has completed and transfers a charging-end signal to the CPU of the charging-state determining-circuit 622ᵢⱼ, and the CPU transfers the charging-end signal to the charging-state displaying circuit.

As illustrated in Fig. 24, focusing on the charging-state determining-circuit 622ᵢ₁, the microprocessor (CPU) 626ᵢ₁ configured to execute an arithmetic operation of the charging-state determining-circuit 622ᵢ₁ is connected to the priority-determining circuit 623ᵢ and, if the charging-end signal is supplied from the charging-state detecting-IC 85, the microprocessor (CPU) 626ᵢ₁ transmits a charging-completion signal to the priority-determining circuit 623ᵢ. In addition, the CPU 626ᵢ₁ receives a priority signal representing a priority order from the priority-determining circuit 623ᵢ. The determining process of the priority order executed by the priority-determining circuit 623ᵢ, for example, similar to the determination of the priority order in the charging system according to the first embodiment, may be conducted using the procedure of feeding a charging-completion signal to the priority-determining circuit 623ᵢ.

More specifically, in the charging system according to the first embodiment, in Step S11 illustrated in Fig. 11, the reference-charge-period determining-circuit 522ᵢ₁ has checked that the charging-start-flag is put up and then has executed the process of advancing the counters 1 to 3 by one or resetting the counters in accordance with the input of the charging-completion signal to each of the boards 1 to 3 as illustrated in Steps S12 to S20. Similar to the process of Steps S11 to S20, in the charging system according to the third embodiment, the charging-state determining-circuit 622ᵢ₁ checks that the charging-start-flag is put up and then, executes the process of advancing the corresponding counters 1 to 3 by one or resetting the counters in accordance with the necessity of the input of the charging-completion signal using each of the charging-state determining-circuit 622ᵢ₁ --board 1-- to the charging-state determining-circuit 622ᵢ₃ --board 3--.

In addition, also for the charging-state determining-circuit 622ᵢ₂, similar to the case of the operation of the reference-charge-period determining-circuit 522ᵢ₂ in Steps S21 to S30 illustrated in Fig. 12, the counters 1 to 3 are advanced by one, or the counters 1 to 3 are reset. Furthermore, also for the charging-state determining-circuit 622ᵢ₃, similar to the case of the operation of the reference-charge-period determining-circuit 522ᵢ₃ in Steps S31 to S40 illustrated in Fig. 13, the counters 1 to 3 are advanced by one, or the counters 1 to 3 are reset. Also in the case of the charging system according to the third embodiment, the values of the counters 1 to 3 corresponding to a plurality of charge-scheduled devices are generated, respectively.

Then, similar to the charging system according to the first embodiment, in which, after the values of the counters 1 to 3 are generated, in Step S41 illustrated in Fig. 14, the priority-determining circuit 523i declares the confirmation of the priority order, which has selected the counter 1 in the reference-charge-period determining-circuit 522ii as the canonical counter for comparison. And, as illustrated in Steps S41 to S46, the priority-determining circuit 523i executes the process of comparing the values of the counters 1 to 3 in the boards 1 to 3, respectively, and executes the process of turning on or off of the preferential display by the board 1 in accordance with a result of the comparison. Similar to the process of Steps S41 to S46, the priority-determining circuit 523i of the charging system according to the third embodiment selects the counter 1 as the canonical counter for comparison and then executes the process of comparing the values of the counters 1 to 3 of the boards 1 to 3 and the process of turning on or off of the preferential display by the board 1 in accordance with a result of the comparison.

In addition, the priority-determining circuit 523i, similar to the case of the operation performed in Steps S51 to S56 illustrated in Fig. 15, compares the values of the counters 1 to 3 of the boards 1 to 3 of a case where the counter 2 of the board 2 is selected as the canonical counter for comparison and turns on or off of the preferential display by the board 2 in accordance with a result of the comparison. Furthermore, similar to the case of the operation performed in Steps S61 to S66 illustrated in Fig. 16, the values of the counters 1 to 3 of the boards 1 to 3 are compared when the counter 3 of the board 3 is selected as the canonical counter for comparison, and the preferential display of the board 3 is turned on or off in accordance with a result of the comparison.

In other words, a method of determining the priority order in the charging system according to the third embodiment can be explained as a process equivalent to a method in which the "board 1", the "board 2", and the "board 3" of the first embodiment are rephrased by the "charging-state determining-circuit 622ᵢ₁", the "charging-state determining-circuit 622ᵢ₂" and the "charging-state determining-circuit 622ᵢ₃", respectively. In the charging system according to the first embodiment, the "reference-charge-period determining-circuit 522ᵢ₁", the "reference-charge-period determining-circuit 522ᵢ₂", and the "reference-charge-period determining-circuit 522ᵢ₃" illustrated in Figs. 11 to 16 are abbreviated as the "board 1", the "board 2", and the "board 3", respectively, so as to explain the method of determining the priority order.

In Fig. 24, although the charging-state displaying circuit is not illustrated in the drawing, the CPU 626ᵢ₁ of the charging-state determining-circuit 622ᵢ₁ is connected to the under-charging-state display-lamp 542ᵢ₁, the charge-completion display-lamp 543ii, and the priority display-lamp 544ᵢ₁, respectively, through the charging-state displaying circuit, after passing through respective I/O interfaces. And the CPU 626ᵢ₁ drives the under-charging-state display-lamp 542ᵢ₁, the charge-completion display-lamp 543ᵢ₁, and the priority display-lamp 544ᵢ₁ through the I/O interfaces, therefore, displaying the under-charging state or the charge-completed state of one of the charge-scheduled devices, while displaying the priority order of the charge-scheduled device. For example, the CPU 626ᵢ₁ of the charging-state determining-circuit 622ᵢ₁ turns on the under-charging-state display-lamp 542ᵢ₁ when a charging-start signal is fed, turns on the charge-completion display-lamp 543ᵢ₁ when a charging-end signal is fed thereafter, and turns on the priority display-lamp 544ᵢ₁ when a priority signal is further fed.

As illustrated on the left side in Fig. 24, since the supply of electric power to the charging-state determining-circuit 622ᵢ₁ can be started at timing when the power supply 590 operates, an on/off button dedicated for controlling the supply of electric power to the charging-state determining-circuit 622ᵢ₁ or a means or the like equivalent to the on/off button is unnecessary. The other charging-state determining-circuits 622ᵢ₂, 622ᵢ₃, ...... have a configuration similar to that illustrated in Fig. 24, although the other charging-state determining-circuits 622ᵢ₂, 622ᵢ₃, ...... are not illustrated. And each of the charging-state determining-circuits 622ᵢ₂, 622ᵢ₃, ...... drives lamps of a corresponding display portion by using a similar configuration and a similar operation.

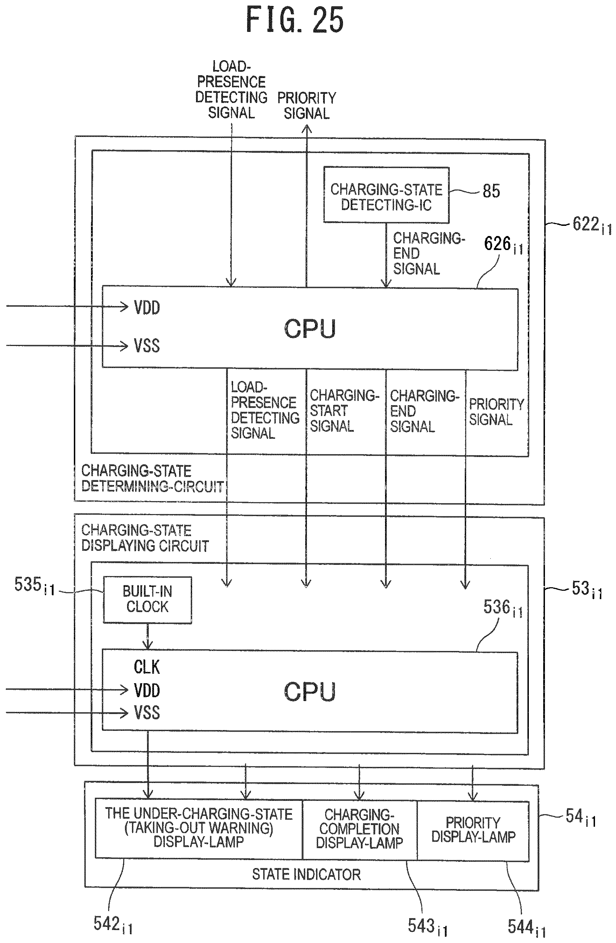

A block diagram of Fig. 25 illustrates a transferring state of a load-presence detecting signal, a charging-start signal, a charging-end signal, and a priority signal from the CPU 626ᵢ₁ of the charging-state determining-circuit 622ᵢ₁ to the charging-state displaying circuit 53ᵢ₁ which is not illustrated in Fig. 24. The charging-state displaying circuit 53ᵢ₁ according to the third embodiment, similar to the charging-state displaying circuit 53ᵢ₁ according to the first and second embodiments illustrated in Fig. 8, includes a microprocessor (CPU) 536ᵢ₁ that executes an arithmetic operation and a built-in clock 535ᵢ₁. The other configurations of the charging-state displaying circuit 53ᵢ₁ are similar to those of the charging-state displaying circuit 53ᵢ₁ illustrated in Fig. 8.

According to the charging system of the third embodiment, similar to the case of a combination of the load-presence detecting circuit 51i and the reference-charge-period determining-circuits 522ᵢ₁, 522ᵢ₂, 522ᵢ₃, ...... in the charging systems according to the first and second embodiments, the load-presence detecting circuit 51ᵢ and the charging-state determining-circuits 622ᵢ₁, 622ᵢ₂, 622ᵢ₃, ...... are included, therefore, the procedure of turning the switch on at the start of charging and turning off the switch, when the device is taken out, is unnecessary, and the installation of on/off buttons and the like is unnecessary. Therefore, similar to the charging systems according to the first and second embodiments, a fault of arbitrarily turning on the switch when the charge-scheduled device IUCᵢⱼ is not connected disappears, and no fault at the time of determining the priority order exists.

In addition, according to the charging system of the third embodiment, similar to the charging systems according to the first and second embodiments, a charging system can be provided which facilitate simultaneous charging of a plurality of charge-scheduled devices IUC₁ₐ, IUC₂ₐ, ..., IUC₅ₐ; IUC_{1b}, IUC_{2b}, ..., IUC_{5b} and individual managing of the plurality of charge-scheduled devices IUC₁ₐ, IUC₂ₐ, ..., IUC₅ₐ; IUC_{1b}, IUC_{2b}, ..., IUC_{5b}, including the degradation of rechargeable batteries, by accurately monitoring the charged statuses of the plurality of charge-scheduled devices IUC₁ₐ, IUC₂ₐ, ..., IUC₅ₐ; IUC_{1b}, IUC_{2b}, ..., IUC_{5b} and by preventing the imbalances in the use-frequencies of the plurality of charge-scheduled devices IUC₁ₐ, IUC₂ₐ, ..., IUC₅ₐ; IUC_{1b}, IUC_{2b}, ..., IUC_{5b} ascribable to the differences in the charging-period.

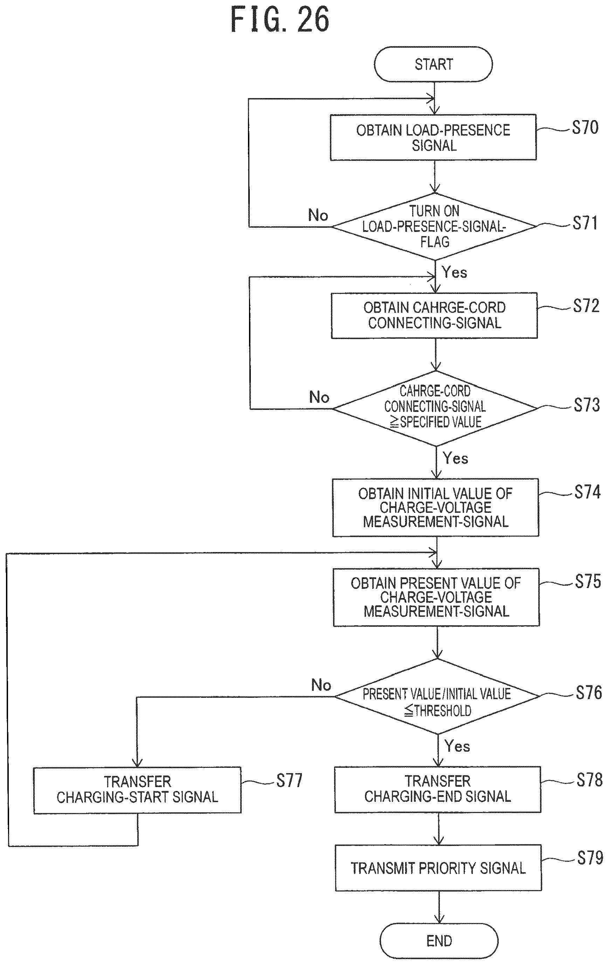

The operation of the charging system according to the third embodiment will be described with reference to a flowchart illustrated in Fig. 26. Similar to the case of the charging systems according to the first and second embodiments, the operation of the charging system described below is an example, and, the operation can be realized using other various operation methods including the modified examples as long as the modified examples are within the technical scope prescribed by the claims.
(a) First, in Step S70 illustrated in Fig. 26, the charging-state determining-circuit 622ᵢⱼ obtains a load-presence signal. Then, in Step S71, the charging-state determining-circuit 622ᵢⱼ determines whether or not a load-presence signal is entered from the load-presence detecting circuit 51i to the charging-state determining-circuit 622ᵢⱼ, while the load-presence signal flag is put up on the software program, And if the load-presence signal flag is not put up, again proceeds to Step S70 and obtains a load-presence signal. In Step S71, if the load-presence signal flag is determined to be set, the flow proceeds to Step S72, and the charging-state determining-circuit 622ᵢⱼ obtains charge-cord connecting-signal. More specifically, a minute AC voltage-waveform signal is generated based on the charging-current signal fed to the current sensor 81a. Then, a DC-voltage signal is generated using the voltage rectifying circuit 84 based on the generated minute AC voltage-waveform signal. Then, based on the generated DC-voltage signal, charge-cord connecting-signal is generated using the first voltage-waveform amplify-element 82a.
(b) Next, in Step S73, the charging-state detecting-IC 85 of the charging-state determining-circuit 622ᵢⱼ determines whether or not the charge-cord connecting-signal is a specified value or more. The specified value may be appropriately set based on a rule of thumb. When the charge-cord connecting-signal is less than the specified value, the charging-state determining-circuit 622ᵢⱼ proceeds to Step S72 and, again, obtains the charge-cord connecting-signal. By arranging the specified value, a signal generated according to a noise such as an external disturbance is excluded, therefore, the accuracy of the determination whether the charge-cord 41ᵢⱼ is in the connected state can be improved.

In Step S73, if the charging-state detecting-IC 85 of the charging-state determining-circuit 622ᵢⱼ determines that the charge-cord connecting-signal is the specified value or more, the flow proceeds to Step S74, and an initial value of the charge-voltage measurement-signal is obtained. More specifically, based on the DC-voltage signal supplied from the voltage rectifying circuit 84, a charge-voltage measurement-signal is generated by the second voltage-waveform amplify-element 82b, and the value of the charge-voltage measurement-signal obtained initially is stored as an initial value in the temporary memory together with the charge-cord connecting- signal.
(c) Next, in Step S75, the charging-state detecting-IC 85 of the charging-state determining-circuit 622ᵢⱼ obtains a present value of the charge-voltage measurement-signal and stores the obtained present value in the temporary memory.

Next, in Step S76, the charging-state detecting-IC 85 of the charging-state determining-circuit 622ᵢⱼ executes a comparing process in which whether the quotient obtained by dividing the present value of the charge-voltage measurement-signal by the initial value is a threshold or less is determined. The threshold may be appropriately set to a proper value. For example, the threshold may be set to about 0.2, or about 20%, based on a rule of thumb.
(d) If the quotient obtained by dividing the present value by the initial value is determined to exceed the threshold, the charging-state detecting-IC 85 determines that charging is started, and the flow proceeds to Step S77. In Step S77, a charging-start signal is transferred to the CPU of the charging-state determining-circuit 622ᵢⱼ, and the operation sequence returns to Step S75. And in Step S75, the present value of the charge-voltage measurement-signal is obtained again. As long as the quotient obtained by dividing the present value by the initial value is determined to exceed the threshold, the process of Step S75 is repeated, and the "present value" is updated every time when the present value is obtained.

In Step S76, if the value obtained by dividing the present value of the charge-voltage measurement-signal by the initial value is determined to be less than the threshold, the charging-state detecting-IC 85 determines that charging has been completed, and the flow proceeds to Step S78. In Step S78, a charging-end signal is transferred to the CPU of the charging-state determining-circuit 622ᵢⱼ, and the CPU transfers a charging-completion signal to the priority-determining circuit 623ᵢⱼ.
(e) Next, in Step S79, the priority-determining circuit 623ᵢⱼ of the charging system transmits a priority signal to the CPU of the charging-state determining-circuit 622ᵢⱼ of a corresponding charge-scheduled device, and the CPU that has received the priority signal transfers the priority signal to the charging-state displaying circuit 53ᵢⱼ. Then, the charging-state displaying circuit 53ᵢⱼ, to which the priority signal has been fed, transfers the priority signal to a corresponding charging-state displaying circuit, and drives the priority display-lamp 544ᵢⱼ. According to a series of the processes from Steps S71 to S79 described above, the process of determining the charging-state is built up.

As mentioned above, according to the operation of the charging system pertaining to the third embodiment of the present invention, contrary to the charging systems pertaining to the first and second embodiments, the counting of a predetermined period (for example, 15 hours) is not required, without causing a state in which the current-detecting signal is not fed is continued for a predetermined time (for example, for ten minutes). That is, by using the charging-state determining-circuit 622ᵢⱼ, a charging-current for each of a plurality of charge-scheduled devices is detected so that a charging-state of each charge-scheduled device can be determined based on the detected charging-current, and, if a charge-completed state is determined, the charge-completed state is displayed by the charging-completion display-lamp. Therefore, without charging for a predetermined period not matching the battery remaining amount of each charge-scheduled device, charging can be appropriately performed using a time corresponding to the battery residual amount of each charge-scheduled device.

In addition, when the counting of a predetermined period using the reference-charge-period determining-circuit is performed, there is a case that even when the charging completes, one of the charge-scheduled devices cannot be used until the predetermined period elapses. According to the operation of the charging system pertaining to the third embodiment, because a charge-completed state is displayed based upon the timing at which the charging of each of a plurality of charge-scheduled devices is completed, unnecessary waiting is not required, and therefore, one of the charge-scheduled devices of which charging has been completed can be quickly used. The other technical effects of the charging system according to the third embodiment are similar to those of the charging systems according to the first and second embodiments.

### (FOURTH EMBODIMENT)

The charging system according to a fourth embodiment of the present invention is based on the configuration of the charging system according to the third embodiment, includes a determination whether or not each of a plurality of charge-scheduled devices has an EL fault, and determines priority in the use order of the charge-scheduled devices.

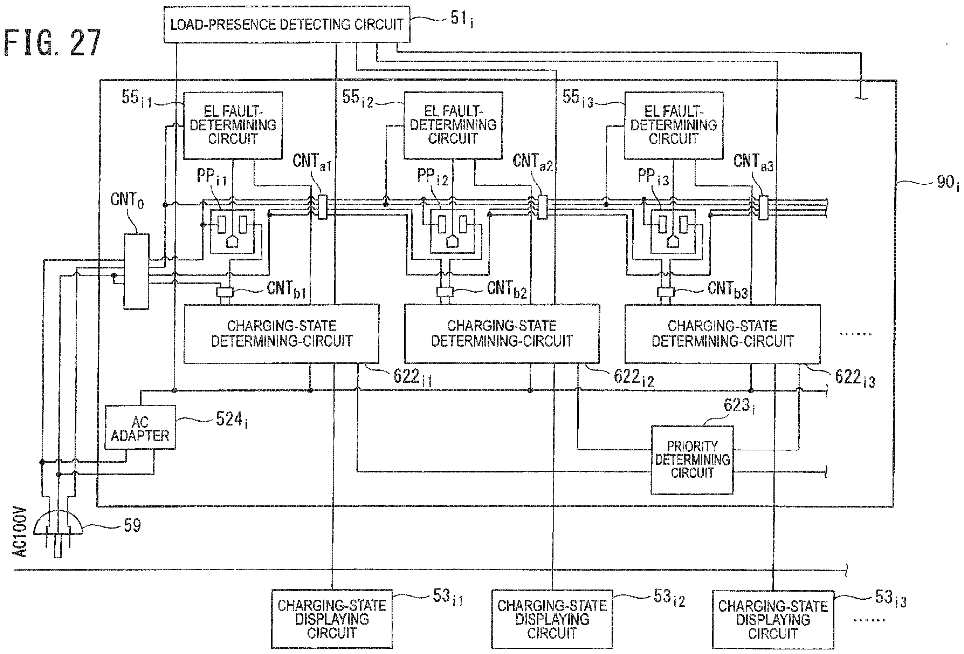

A charging-state managing circuit 90ᵢ of the charging system according to the fourth embodiment, as illustrated in a block diagram of Fig. 27, includes: charging-state determining-circuits 622ᵢ₁, 622ᵢ₂, 622ᵢ₃, ...... that independently measure changes of currents supplied from commercial power to charge-scheduled devices that are charged from a plurality of power-feeding units PPᵢ₁, PPᵢ₂, PPᵢ₃, ...... and determines the charging-state of each of the charge-scheduled devices; and a priority-determining circuit 623i that determines priority in the use order of a plurality of the charge-scheduled devices based on the charging-state of each of the charge-scheduled devices under a condition such that the plurality of charge-scheduled devices including charge-scheduled devices of which charging has completed are connected to a plurality of power-feeding units PPᵢ₁, PPᵢ₂, PPᵢ₃, .......

In addition, the charging-state managing circuit 90i includes earth-leakage (EL) fault determining-circuits 55ᵢ₁, 55ᵢ₂, 55ᵢ₃, ...... that determine necessity of an EL fault state in each charge-scheduled device based on a change in an EL current for charge-scheduled devices that are charged by a plurality of power-feeding units PPᵢ₁, PPᵢ₂, PPᵢ₃, ....... The charging-state managing circuit 90i implementing the charging system according to the fourth embodiment is connected to charging-state displaying circuits 53ᵢ₁, 53ᵢ₂, 53ᵢ₃, ...... that display whether each of a plurality of charge-scheduled devices is in the "under-charging" state, the "charge-completed" state, or in the "EL fault" state, and further displays the priority order in the plurality of charge-scheduled devices.

In other words, the charging system according to the fourth embodiment has a configuration, which includes further the EL fault determining-circuits 55ᵢ₁, 55ᵢ₂, 55ᵢ₃, ...... in addition to the configuration similar to that of the charging system according to the third embodiment. In the charging system according to the fourth embodiment, configurations other than the EL fault determining-circuits 55ᵢ₁, 55ᵢ₂, 55ᵢ₃, ...... and the priority-determining circuit 623ᵢ are substantially the same as the constituent elements of the first to third embodiments having the same names, therefore, hereinafter, duplicate description will not be presented, and, mainly, the EL fault determining-circuits 55ᵢ₁, 55ᵢ₂, 55ᵢ₃, ...... and the priority-determining circuit 623ᵢ will be described.

As illustrated in Fig. 27, in the charging-state managing circuit 90i of the fourth charging system, an earth wire among single-phase three lines extending from an AC power plug 59 branches between a connector CNT₀ and the grounding terminal of a bipolar socket with grounding appliance included in the power-feeding unit PPᵢ₁. The EL fault determining-circuit 55ᵢ₁ is connected between one of branching earth wires and the grounding terminal of the power-feeding unit PPᵢ₁.

In addition, the other of the branching earth wires is directly connected to a connector CNTₐ₁ and extends up to a connector CNTₐ₂ and branches between the connector CNTₐ₁ and the connector CNTₐ₂. Between the earth wire branching between the connector CNTₐ₁ and the connector CNTₐ₂ and the grounding terminal of the power-feeding unit PPᵢ₂ of a next stage, the EL fault circuit 55ᵢ₂ of a next stage is connected.

Furthermore, earth wire extending from the connector CNTₐ₂ is directly connected to a connector CNTₐ₃ and extends up to the connector CNTₐ₃ and branches between the connector CNTₐ₂ and the connector CNTₐ₃. Between the earth wire branching between the connector CNTₐ₂ and the connector CNTₐ₃ and the grounding terminal of the power-feeding unit PPᵢ₃ of a next stage, the EL fault circuit 55ᵢ₃ of a next stage is connected.

In addition, the EL fault determining-circuit 55ᵢ₁ is connected to the charging-state determining-circuit 622ᵢ₁, the EL fault determining-circuit 55ᵢ₂ is connected to the charging-state determining-circuit 622ᵢ₂, and the EL fault determining-circuit 55ᵢ₃ is connected to the charging-state determining-circuit 622ᵢ₃.

Furthermore, each of the EL fault determining-circuits 55ᵢ₁, 55ᵢ₂, 55ᵢ₃......, similar to the charging-state determining-circuit 622ᵢⱼ, is connected to charging cord which is not illustrated through a bypass wiring or the like, and a grounding-current signal is fed to each of the EL fault determining-circuits 55ᵢ₁, 55ᵢ₂, 55ᵢ₃...... through the charging cord.

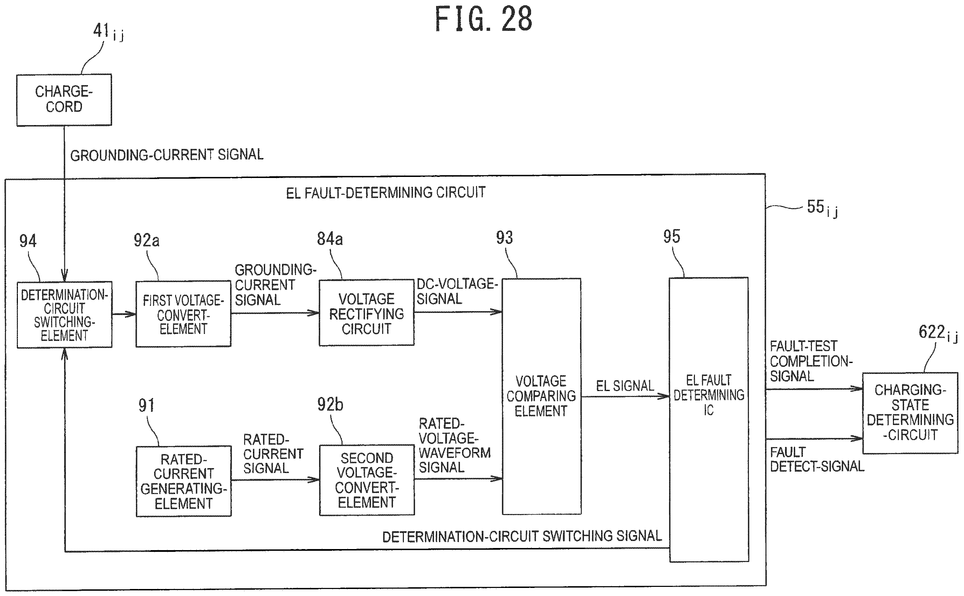

The EL fault determining-circuit 55ᵢⱼ, as illustrated in a block diagram of Fig. 28, includes a determination-circuit switch-element 94 that is connected to the charging cord through a wiring or the like, a first voltage-convert-element 92a that is connected to a later stage of the determination-circuit switch-element 94, a voltage rectifying circuit 84a that is connected to a later stage of the first voltage-convert-element 92a, and a voltage-comparing element 93 that is connected to a later stage of the voltage rectifying circuit 84a.

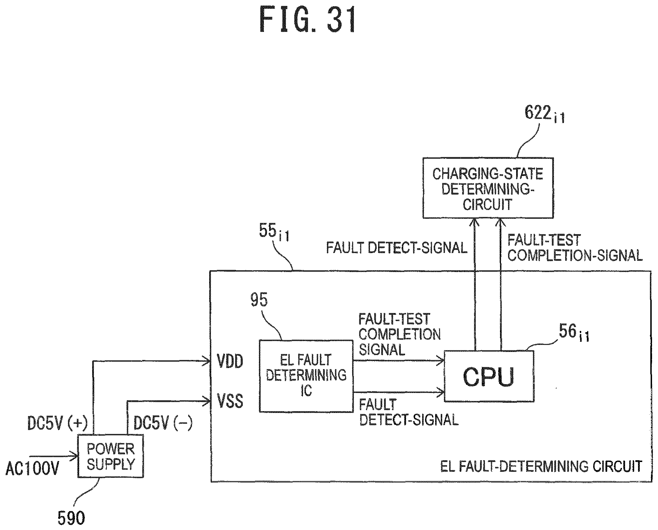

In addition, the EL fault determining-circuit 55ᵢⱼ includes a rated-current generating-element 91 that a rated-current signal that is a reference for a determination of an EL fault; and a second voltage-convert-element 92b that is connected to a later stage of the rated-current generating-element 91. The second voltage-convert-element 92b is connected to the voltage-comparing element 93. In addition, the EL fault determining-circuit 55ᵢⱼ includes an EL fault determining IC 95 that is connected to a later stage of the voltage-comparing element 93. The EL fault determining IC 95 is connected to the determination-circuit switch-element 94. In addition, the EL fault determining-circuit 55ij includes a microprocessor (CPU) that is connected to the EL fault determining IC 95 as represented as a CPU 56ᵢ₁ in a block diagram of FIG. 31 as an example.

The determination-circuit switch-element 94 is switchable between the on-operation and the off-operation such that the determination-circuit switch-element 94 transfers the entered grounding-current signal to the first voltage-convert-element 92a in the on-state, and that the determination-circuit switch-element 94 blocks the entered grounding-current signal so as not to be transferred to the first voltage-convert-element 92a in the off-state.

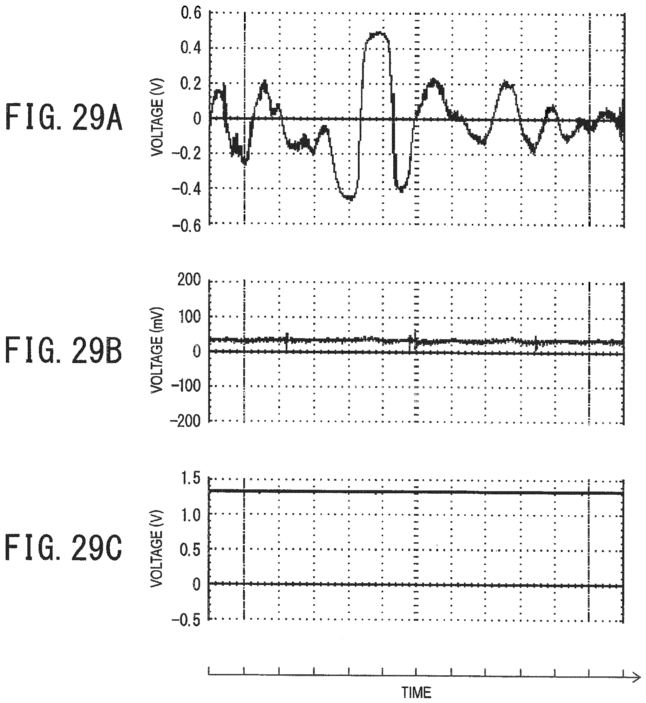

The first voltage-convert-element 92a executes a current-to-voltage conversion of the entered grounding-current signal and provides a minute EL-voltage signal. In a waveform diagram of Fig. 29A, the AC minute EL-voltage signal having a maximum amplitude of about 500 mV, which is generated by the first voltage-convert-element 92a in accordance with the entered grounding-current signal when an EL fault does not occur in one of the charge-scheduled devices, is illustrated as an example. In addition, if the charge-cord 41ᵢⱼ is not connected to the power-feed cord 31ᵢⱼ, the grounding-current signal is not fed, and the minute EL-voltage signal does not appear.

The AC minute EL-voltage signal is fed to the voltage rectifying circuit 84a. The voltage rectifying circuit 84a executes full-wave rectification by inverting the negative-side waveform of the minute EL-voltage signal to the waveform of the positive side and smoothing the waveform and transfers a resultant signal as a DC-voltage signal. In a waveform diagram of Fig. 29B, a DC-voltage signal of about 30 mV, which is generated by the voltage rectifying circuit 84a in response to the input of the minute EL-voltage signal at a normal state illustrated in Fig. 29A, is illustrated as an example.

On the other hand, in a waveform diagram of Fig. 29C, a DC-voltage signal of about 1.3 volts, which is generated by the voltage rectifying circuit 84a in response to a minute EL-voltage signal that is fed in the abnormal state in which an EL fault occurs, is illustrated as an example. The waveform after the full-wave rectification performed by the voltage rectifying circuit 84a is formed to be a waveform of a relatively small value, of which the measurement range is a 100 mV class in a normal state, and to be a waveform of a relatively large value, of which the measurement range is a 500 mV --0.5 volt-- class in an abnormal state. Therefore, by suppressing an occurrence of an erroneous determination for the necessity of the EL fault, the accuracy of the determination can be improved.

As the rated-current signal generated by the rated-current generating-element 91, for example, a value of 0.5 mA or more defined as an EL fault in the Japanese Industrial Standards (JIS T 0601-1 1999) may be used.

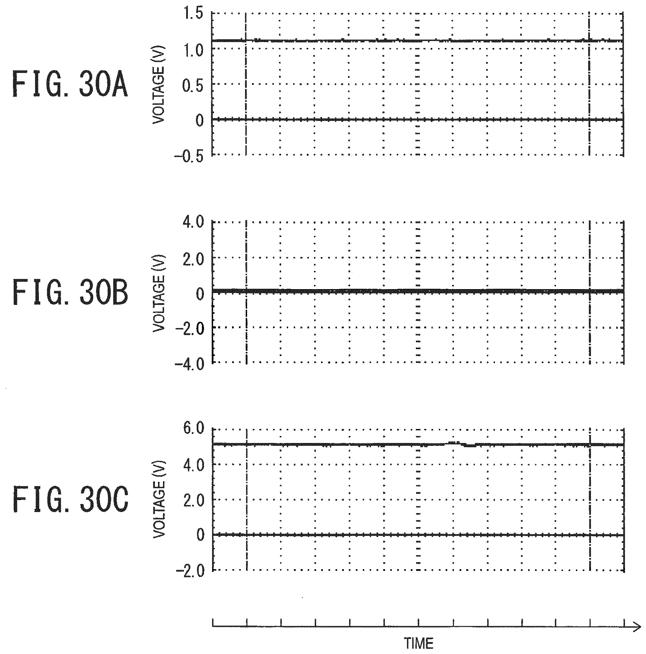

The rated-current signal is fed to the second voltage-convert-element 92b, and the second voltage-convert-element 92b executes a current-to-voltage conversion of the entered rated-current signal to be in a range that can be used by the voltage-comparing element 93 and transfers a converted signal as a rated voltage waveform-signal. In a waveform diagram of Fig. 30A, the rated DC-voltage waveform-signal of about 1.1 volts, which is generated by the second voltage-convert-element 92b in response to an entered rated-current signal of 0.5 mA, is illustrated as an example.

The rated voltage waveform-signal is fed to the voltage-comparing element 93, and the voltage-comparing element 93 compares the entered rated voltage waveform-signal with the DC-voltage signal and transfers an EL signal representing an occurrence of the EL fault to the EL fault determining IC 95, if the magnitude of the DC-voltage signal exceeds the magnitude of the rated voltage waveform-signal. On the other hand, if the magnitude of the DC-voltage signal is the magnitude of the rated voltage waveform-signal or less, the voltage-comparing element 93 does not transfer the EL signal.

In a waveform diagram of Fig. 30B, when both of the DC-voltage signal illustrated in Fig. 29B and the rated voltage waveform-signal illustrated in Fig. 30A are fed, a state such that the transferred signal of the voltage-comparing element 93 is zero is illustrated as an example. In other words, a state in which the EL signal is not transferred is illustrated in Fig. 30B. At the time, the DC-voltage signal is about 30 mV, and the rated voltage waveform-signal is about 1.1 volts, and accordingly,
DC-voltage signal < rated voltage waveform-signal

On the other hand, in a waveform diagram of Fig. 30C, when the DC-voltage signal illustrated in Fig. 29C and the rated voltage waveform-signal illustrated in Fig. 30A are fed, a state in which the voltage-comparing element 93 transfers the EL signal of a DC voltage of about 5.2 volts is illustrated as an example. At the time, the DC-voltage signal is about 1.3 volts, and the rated voltage waveform-signal is about 1.1 volts. And accordingly,
DC-voltage signal > rated voltage waveform-signal

The EL fault determining IC 95, in an off state to which the EL signal is not fed, determines that the charge-scheduled device is in a normal state and transfers only a fault-test completion-signal to the CPU of the EL fault determining-circuit 55ᵢⱼ. On the other hand, the EL fault determining IC 95, in an on-state in which the EL signal is fed, determines that the charge-scheduled device is in a fault-state and transfers both a fault-test completion-signal and a fault detect-signal to the CPU of the EL fault determining-circuit 55ᵢⱼ. In other words, the EL fault determining IC 95 does not transferred the fault detect-signal if the charge-scheduled device is in the normal state.

In addition, the EL fault determining IC 95 a determination-circuit switching signal used for switching between on/off of the determination-circuit switch-element 94 and transfers the generated determination-circuit switching signal to the determination-circuit switch-element 94. When the EL fault determining process is started, the EL fault determining IC 95 transfers the determination-circuit switching signal to the determination-circuit switch-element 94, therefore, turning on the determination-circuit switch-element 94. In addition, when the EL fault determining process completes, the EL fault determining IC 95 stops the transmission of the determination-circuit switching signal to the determination-circuit switch-element 94 so as to turn off the determination-circuit switch-element 94.

As illustrated in Fig. 31, focusing on the inside of the EL fault determining-circuit 55ᵢ₁, the microprocessor (CPU) 56ᵢ₁ that executes an arithmetic operation of the EL fault determining-circuit 55ᵢ₁ is connected to the charging-state determining-circuit 622ᵢ₁. Therefore, when the fault-test completion-signal and the fault detect-signal are supplied from the EL fault determining IC 95, the EL fault determining-circuit 55ᵢ₁ transmits the fault-test completion-signal and the fault detect-signal to the charging-state determining-circuit 622ᵢ₁ through the CPU 56ᵢ₁.

As illustrated on the left side in Fig. 31, since the supply of electric power to the EL fault determining-circuit 55ᵢ₁ can be started at timing when the power supply 590 operates, similar to the case of the charging-state determining-circuit 622ᵢ₁, an on/off button dedicated for controlling the supply of electric power to the EL fault determining-circuit 55ᵢ₁ or a means or the like equivalent to the on/off button is unnecessary. The other EL fault determining-circuits 55ᵢ₂, 55ᵢ₃, ...... have a configuration similar to the configuration illustrated in Fig. 31, respectively, although the other EL fault determining-circuits 55ᵢ₂, 55ᵢ₃, ...... are not illustrated.

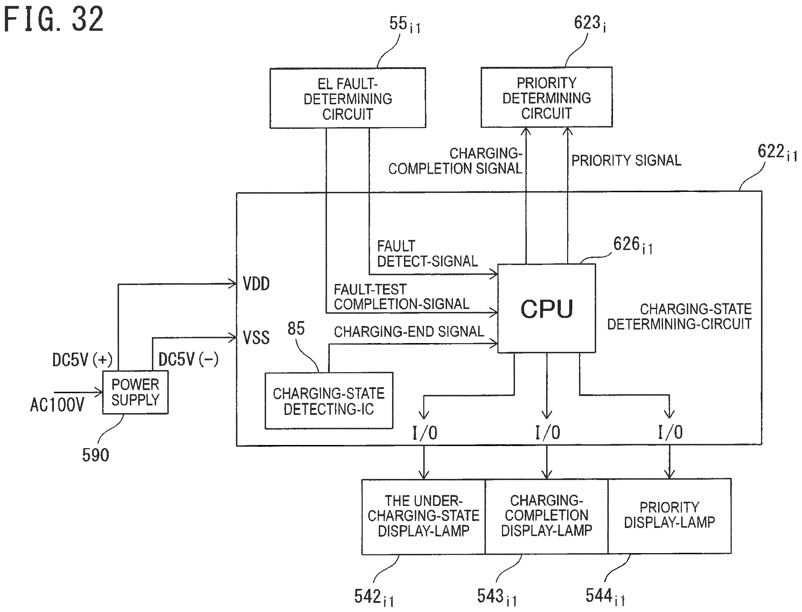

In a block diagram of Fig. 32, a part of input-output states of various signals are schematically illustrated, focusing on the CPU 626ᵢ₁ of the charging-state determining-circuit 622ᵢⱼ. In a state in which a load-presence signal is supplied from the load-presence detecting circuit 51ᵢ, in other words, when the load-presence signal flag is on-state on the software program, and if only the fault-test completion-signal is fed to the CPU 626ᵢ₁ of the charging-state determining-circuit 622ᵢⱼ, and the fault-test completion-signal flag is on-state, the charging-state determining-circuit 622ij executes the process of Step S72 and subsequent steps described with reference to Fig. 26 and determines the charging-state of each charge-scheduled device.

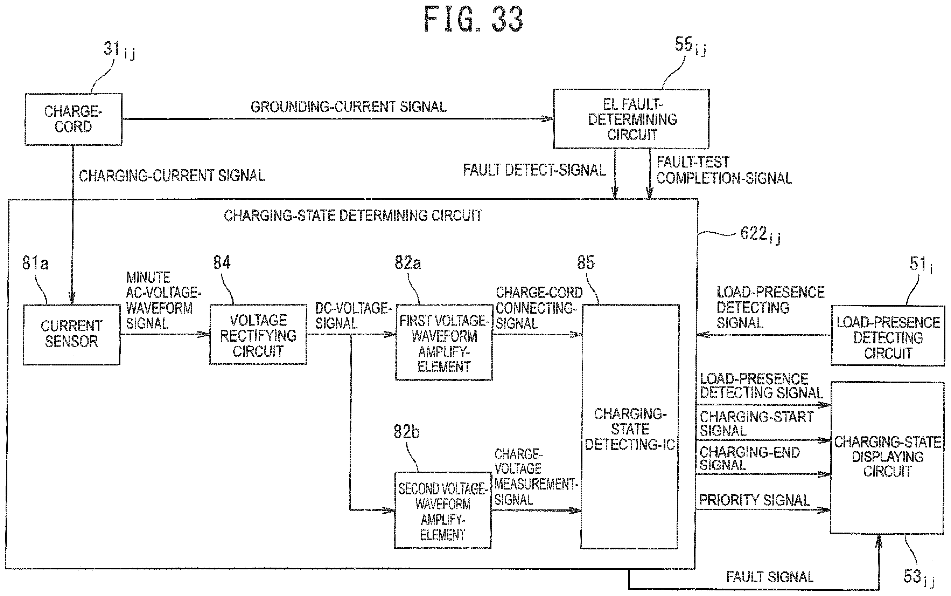

On the other hand, when the load-presence signal flag is on-state, and, as a combination of the fault-test completion-signal and the fault detect-signal is fed, and, if both the fault-test completion-signal flag and the fault detect-signal flag are on-states, the charging-state determining-circuit 622ᵢⱼ, as illustrated in a block diagram of Fig. 33, transfers a fault signal to the charging-state displaying circuit 53ᵢⱼ. The charging-state displaying circuit 53ᵢⱼ may visually display a fault-state, for example, by blinking all the under-charging-state display-lamp, the charge-completion display-lamp, and the priority display-lamp if the fault signal is fed.

Alternatively, an alarm unit such as a buzzer, which is not illustrated, may be connected to the charging-state determining-circuit 622ᵢⱼ so as to emit a warning sound, if a fault signal is fed to the alarm unit, so that the fault-state can be recognized through an auditory sense. Then, the charging-state managing circuit 90i can exclude a specific one of the charge-scheduled devices, in which the EL fault is occurring, from the targets for determining the charging-states.

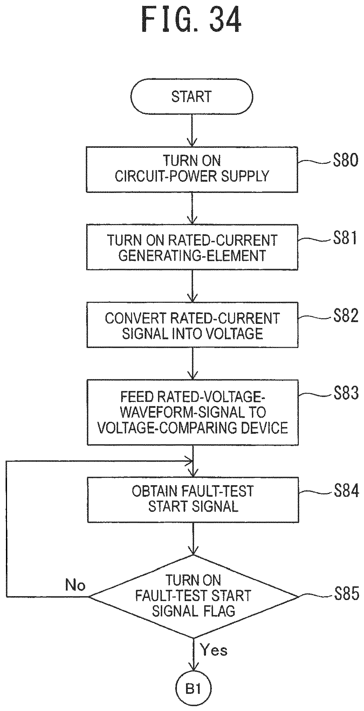

The operation of the charging system according to the fourth embodiment will be described with reference to flowcharts illustrated in Fig. 34. The operation of the charging system described below is an example, and, similar to the case of the charging systems according to the first to third embodiments, the operation can be realized using other various operation methods including the modified examples as long as the modified examples are within the technical scope prescribed by the claims.
(a) First, in Step S80 illustrated in Fig. 34, the power of the EL fault determining-circuit 55ij is turned on. Next, in Step S81, by turning on the rated-current generating-element 91 of the EL fault determining-circuit 55ij to be driven, a rated-current signal is generated and is fed to the second voltage-convert-element 92b. Next, in Step S82, the rated-current signal is converted into a rated DC-voltage waveform-signal by using the second voltage-convert-element 92b. Then, in Step S83, the converted rated voltage waveform-signal is fed to the voltage-comparing element 93.
(b) Next, in Step S84, the EL fault determining-circuit 55ij obtains a fault-test start signal. More specifically, for example, the charging-state determining-circuit 622ᵢⱼ obtains the charge-cord connecting-signal, and, at timing at which the charge-cord connecting-signal supplied from the first voltage-waveform amplify-element 82a of the charging-state determining-circuit 622ᵢⱼ as illustrated in Fig. 33 to the charging-state detecting-IC 85 becomes a predetermined specified value or more, a fault-test start signal is transmitted from the charging-state determining-circuit 622ᵢⱼ to the EL fault determining-circuit 55ᵢⱼ so that the flag of the fault-test start signal becomes on-state on the software program of the EL fault determining-circuit 55ᵢⱼ. And, after the state of the flag is checked, if the on-state is confirmed, the fault-test start signal is obtained. Alternatively, if a predetermined fault-test start signal is fed to the EL fault determining-circuit 55ᵢⱼ from the outside, the flag of the fault-test start signal may become on-state.
(c) Next, in Step S85, for example, if the flag of the fault-test start signal is determined to be of-state, the flow proceeds to Step S84, and, again, the fault-test start signal is obtained. In addition, a series of the processes for checking the necessity of the fault-test start signal through Steps S84 and S85 may be performed before a series of the processes for generating the rated voltage waveform-signal through Steps S81 to S83.

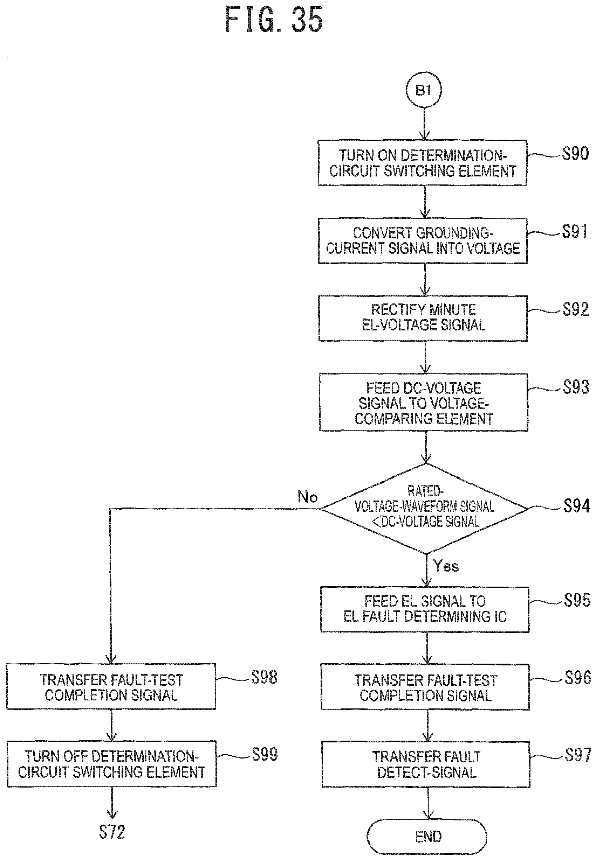

In Step S85, if the flag of the fault-test start signal is determined to be "on-state", the flow proceeds to Step S90 illustrated in Fig. 35. And in Step S90, a determination-circuit switching signal is provided by the EL fault determining IC 95, and the operation of the determination-circuit switch-element 94 is turned on. Then, the grounding-current signal supplied through the charge-cord 41ᵢⱼ is caused to pass through the determination-circuit switch-element 94 and is fed to the first voltage-convert-element 92a.
(d) Next, in Step S91, the grounding-current signal is converted by the first voltage-convert-element 92a so as to generate a minute EL-voltage signal, and the generated minute EL-voltage signal is fed to the voltage rectifying circuit 84a. Next, in Step S92, the minute EL-voltage signal is rectified by the voltage rectifying circuit 84a, therefore, a DC-voltage signal is generated. Then, in Step S93, the generated DC-voltage signal is fed to the voltage-comparing element 93.
(e) Next, in Step S94, the magnitude of the entered DC-voltage signal and the magnitude of the rated voltage waveform-signal fed in Step S83 in advance are compared with each other using the voltage-comparing element 93. If the DC-voltage signal is determined to be more than the rated voltage waveform-signal, an EL fault is determined to have occurred, the flow proceeds to Step S95, and the voltage-comparing element 93 transfers an EL signal to the EL fault determining IC 95. Then, in Step S96, the fault-test completion-signal is transferred by the EL fault determining IC 95 to the CPU 56ᵢⱼ of the EL fault determining-circuit 55ᵢⱼ. Then, in Step S97, the fault detect-signal is transferred to the CPU 56ᵢⱼ of the EL fault determining-circuit 55ᵢⱼ. Through a series of the processes of Steps S80 to S85 and Steps S90 to S97, a fault test by which the EL fault can be determined completes.
(f) In Step S94, if the DC-voltage signal is determined to be less than the rated voltage waveform-signal, the EL fault is determined not to have occurred, and the flow proceeds to Step S98. In Step S98, a fault-test completion-signal is transferred by the EL fault determining IC 95 to the CPU 56ᵢⱼ of the EL fault determining-circuit 55ᵢⱼ. Then, the flow proceeds to Step 99, and by turning off the output of the determination-circuit switching signal of the EL fault determining IC 95, the operation of the determination-circuit switch-element 94 is turned off. By turning off the determination-circuit switch-element 94, the input of the grounding-current signal through the charge-cord 41ᵢⱼ is blocked by the determination-circuit switch-element 94, and the input s of the signals to elements disposed in stages after the determination-circuit switch-element 94 is stopped. If the EL fault is determined not to have occurred, the process of Step S72 and subsequent steps illustrated in Fig. 26 are continuously performed so that the determination of the charging-state of charge-scheduled devices and the priority order determining process can be continued. Through a series of the processes of Steps S80 to S85, Steps S90 to S94, and Steps S98 and S99, the fault test of a case where the EL fault is determined not to have occurred completes.

According to the operation of the charging system pertaining to the fourth embodiment of the present invention, by using the EL fault determining-circuit 55ᵢⱼ, the existence or the non-existence of the EL faults of a plurality of charge-scheduled devices can be individually determined in an easy manner. In addition, because an erroneous use of the charge-scheduled device in which the EL fault occurs can be prevented, a situation in which a human body will suffer from an influence of the EL fault can be avoided. The other technical effects of the charging system according to the fourth embodiment are similar to those of the charging systems according to the first to fourth embodiments.

### (OTHER EMBODIMENT)

As described above, while the present invention has been described using the first to fourth embodiments, the description and the drawing forming a part of the disclosure should not be understood to limit the present invention. Various alternative embodiments, examples, and operation technologies become clear to a person skilled in the art based on the disclosure. Therefore, the present invention apparently includes various embodiments and the like not disclosed here.

For example, a charging system according to the present invention may be built up by combining parts of the configurations of the charging systems according to the first to fourth embodiments. Accordingly, the technical scope of the present invention is determined by invention-specific matters relating to the claims that are based on the description presented above.

### [Reference Signs List]

- 21₁, 21₂, 21₃, 21₄: Shelf
- 21: Display panels
- 23a, 23b, 23c, 23d: Leg
- 24a, 24b, 24c, 24d: Moving wheel
- 25₁: Clamp
- 26₁: Mounting board
- 27₁: Suspension bar
- 28₁: Grip
- 29: Pillar portion
- 31₁ₐ, 31_{1b}: Power-feeding cable
- 41ᵢⱼ: Charging cord
- 51ᵢ: Load-presence detecting circuit
- 52ᵢ: Charging-state managing circuit
- 521ᵢ₁, 521ᵢ₂, 521ᵢ₃, 521ᵢⱼ: Charge-end-point detecting-circuit
- 522ᵢ₁, 522ᵢ₂, 522ᵢ₃: Reference-charge-period determining-circuit
- 523ᵢ: Priority-determining circuit
- 525ᵢ₁: Timer
- 526ᵢ₁, 536ᵢ₁: CPU
- 53ᵢ₁, 53ᵢ₂, 53ᵢ₃: Charging-state displaying circuit
- 535ᵢ₁: Built-in clock
- 54ᵢ₁, 54ᵢ₂, 54ᵢ₃: State indicator
- 54: External clock
- 541ᵢ₁: Load-presence display-lamp
- 542ᵢ₁: The under-charging-state display-lamp
- 543ᵢ₁: Charging-completion display-lamp
- 544ᵢ₁, 544ᵢ₂, 544ᵢ₃: Priority display-lamp
- 55ᵢ₁, 55ᵢ₂, 55ᵢ₃: EL fault determining-circuit
- 56ᵢ₁: CPU
- 59: AC power plug
- 590: Power supply
- 62i: Charging-state managing circuit
- 622ᵢ₁, 622ᵢ₂, 622ᵢ₃: Charging-state determining-circuit
- 626ᵢ₁: CPU
- 71a, 71b: Horizontal board
- 72: Power-breaker installation-case
- 73: Top board
- 741, 74₂, 74₃, 74₄: Power-feeder installation-box
- 81, 81a: Current sensor
- 82: Voltage-waveform amplifying device
- 82a: First voltage-waveform amplify-element
- 82b: Second voltage-waveform amplify-element
- 83: Switching device
- 84: Voltage rectifying circuit
- 85: Charging-state detecting-IC
- 92i: Charging-state managing circuit
- 91: Specified-current generating-element
- 92a: Second voltage-convert-element
- 92b: Second voltage-convert-element
- 93: Voltage-comparing element
- 94: Determination-circuit switch-element
- 95: Earth-leakage (EL) fault determining IC

## Claims

1. A charging system comprising:
a mounting mechanism for mounting simultaneously a plurality of charge-scheduled devices;
a plurality of discrete power-feeding units (PPᵢ₁, PPᵢ₂, PPᵢ₃, ......), attached respectively to the mounting mechanism, being independently arranged for the plurality of the charge-scheduled devices, such that the plurality of the power-feeding units (PPᵢ₁, PPᵢ₂, PPᵢ₃, ......) can be simultaneously connected to the plurality of the charge-scheduled devices, respectively;
a charging-state determining-circuit attached to the mounting mechanism, configured to determine charging-states of the charge-scheduled devices, by independently measuring current supplied from commercial power (590) to each of the charge-scheduled devices, which is charged through any one of the plurality of power-feeding units (PPᵢ₁, PPᵢ₂, PPᵢ₃, ......);
a priority-determining circuit (523ᵢ) attached to the mounting mechanism, configured to determine priority order in the plurality of the charge-scheduled devices based on the charging-states of the charge-scheduled devices, under a condition such that the plurality of charge-scheduled devices, which include charging completed charge-scheduled devices, are connected to the plurality of power-feeding units (PPᵢ₁, PPᵢ₂, PPᵢ₃, ......); and
a charging-state displaying circuit (53ᵢ₁, 53ᵢ₂, 53ᵢ₃) configured to display whether each of the plurality of the charge-scheduled devices is in an under-charging state or a charge-completed state, and to display the priority orders for using the plurality of the charge-scheduled devices.

2. The charging system of claim 1, wherein the mounting system comprises a rack having a plurality of shelves (211, 212, 213), and the plurality of power-feeding units (PPᵢ₁, PPᵢ₂, PPᵢ₃, ......) are arranged respectively on the plurality of shelves (21₁, 21₂, 21₃, ......).

3. The charging system of claim 1, wherein the mounting mechanism comprises a tower including:
a box-shaped display panel (21) extending in a height direction, and
a box-shaped pillar portion (29) connected to a center portion of one of side faces of the display panel (21) so as to implement a "T"-shaped, which is viewed in a cross-section cut along a horizontal plane,
wherein the plurality of charge-scheduled devices are arranged on a side wall of the tower.

4. The charging system of claim 2, wherein a plurality of load-presence detecting sensors are arranged, configured to be paired with the plurality of power-feeding units (PPᵢ₁, PPᵢ₂, PPᵢ₃, ......) on the plurality of shelves (21₁, 21₂, 21₃, ......).

5. The charging system of claim 2 or 4, further comprising display portions configured to receive signals of the charging-state displaying circuit (53ᵢ₁, 53ᵢ₂, 53ᵢ₃), and to display under-charging state, the charge-completed state, and the priority orders, the display portions are arranged to be paired with the plurality of power-feeding units (PPᵢ₁, PPᵢ₂, PPᵢ₃, ......) at front end portions of the plurality of shelves (21₁, 21₂, 21₃, ......).

6. The charging system of claim 3, wherein the plurality of power-feeding units (PPᵢ₁, PPᵢ₂, PPᵢ₃, ......) are arranged on a side face of the pillar portion 29 along a height direction.

7. The charging system of claim 3 or 6, further comprising display portions configured to receive signals from the charging-state displaying circuit (53ᵢ₁, 53ᵢ₂, 53ᵢ₃), and to display the under-charging state, the charge-completed state, and the priority orders, the display portions are arranged to be paired with the plurality of power-feeding units (PPᵢ₁, PPᵢ₂, PPᵢ₃, ......) on the display panel 21.

8. The charging system of claim 1, wherein the charging-state determining-circuit comprises:
a charge-end-point detecting-circuit (521ᵢ₁, 521ᵢ₂, 521ᵢ₃, ......) configured to detect charging-start timing and charging-end timing of each of the charge-scheduled devices, by independently measuring change in current supplied from commercial power (590) to each of the charge-scheduled devices, which is charged through any one of the plurality of power-feeding units (PPᵢ₁, PPᵢ₂, PPᵢ₃, ......); and
a reference-charge-period determining-circuit (522ᵢ₁, 522ᵢ₂, 522ᵢ₃, ......) configured to receive information of the charging-start timing from the charge-end-point detecting-circuit (521ᵢ₁, 521ᵢ₂, 521ᵢ₃, ......) and to measure a predetermined reference-charge-period through the charging-start timing of the charge-scheduled devices.

9. The charging system of claim 1, further comprising an earth-leakage fault determining-circuit (55ᵢ₁, 55ᵢ₂, 55ᵢ₃) configured to determine existence or non-existence of an earth-leakage fault in each of the plurality of the charge-scheduled devices.

## Patentansprüche

1. Ladesystem, umfassend:
einen Befestigungsmechanismus zum gleichzeitigen Befestigen einer Vielzahl von zum Laden vorgesehenen Vorrichtungen;
eine Vielzahl von diskreten Einspeiseeinheiten (PPᵢ₁, PRᵢ₂, PRᵢ₃, ...), die jeweils am Befestigungsmechanismus befestigt sind, der unabhängig für die Vielzahl von zum Laden vorgesehenen Vorrichtungen derart angeordnet ist, dass die Vielzahl der Einspeiseeinheiten (PPᵢ₁, PRᵢ₂, PRᵢ₃, ...) gleichzeitig mit der Vielzahl der entsprechenden zum Laden vorgesehenen Vorrichtungen verbunden werden kann;
eine Bestimmungsschaltung für den Ladezustand, die am Befestigungsmechanismus befestigt ist und dafür ausgelegt ist, Ladezustände der zum Laden vorgesehenen Vorrichtungen durch unabhängiges Messen von Strom zu bestimmen, der vom kommerziellen Stromnetz (590) jeder der zum Laden vorgesehenen Vorrichtungen zugeführt wird, die durch eine der Vielzahl von Einspeiseeinheiten (PPᵢ₁, PRᵢ₂, PRᵢ₃, ...) geladen werden;
eine Priorität bestimmende Einheit (523ᵢ), die am Befestigungsmechanismus befestigt ist und dafür ausgelegt ist, die Prioritätsreihenfolge der Vielzahl der zum Laden vorgesehenen Vorrichtungen auf der Basis der Ladezustände der zum Laden vorgesehenen Vorrichtungen zu bestimmen, unter einer solchen Bedingung, dass die Vielzahl der zum Laden vorgesehenen Vorrichtungen, die zum Laden vorgesehene Vorrichtungen mit abgeschlossener Ladung umfassen, an die Vielzahl der Einspeiseeinheiten (PPᵢ₁, PRᵢ₂, PRᵢ₃, ...) angeschlossen wird; und
eine den Ladezustand anzeigende Einheit (53ᵢ₁, 53ᵢ₂, 53ᵢ₃), die dafür ausgelegt ist, anzuzeigen, ob jede der Vielzahl der zum Laden vorgesehenen Vorrichtungen in einem schwach geladenen Zustand oder einem Zustand mit abgeschlossener Ladung ist, und die zum Anzeigen der Prioritätsreihenfolgen zur Verwendung der Vielzahl der zum Laden vorgesehenen Vorrichtungen ausgelegt ist.

2. Ladesystem nach Anspruch 1, wobei das Befestigungssystem ein Regal umfasst, das eine Vielzahl von Regalböden (211, 212, 213) hat, und die Vielzahl von Einspeiseeinheiten (PPᵢ₁, PPᵢ₂, PPᵢ₃, ...) ist jeweils auf der Vielzahl von Regalböden (21₁, 21₂, 21₃,...) angeordnet.

3. Ladesystem nach Anspruch 1, wobei der Befestigungsmechanismus einen Turm enthält, umfassend:
ein kastenförmiges Anzeigefeld (21), das sich in einer Höhenrichtung erstreckt, und
einen kastenförmigen Säulenteil (29), der mit einem Mittelteil von einer der Seitenflächen des Anzeigefeldes (21) verbunden ist, um so eine "T"-Form zu realisieren, die in einem Querschnitt entlang einer Horizontalebene betrachtet wird,
wobei die Vielzahl der zum Laden vorgesehenen Vorrichtungen auf einer Seitenwand des Turms eingeordnet ist.

4. Ladesystem nach Anspruch 2, wobei eine Vielzahl von Sensoren zur Feststellung einer Last angeordnet ist, die dafür ausgelegt sind, mit der Vielzahl von Einspeiseeinheiten (PRil, PPi2, PPi3, ...) auf der Vielzahl von Regalböden (211, 212, 213, ...) gekoppelt zu werden.

5. Ladesystem nach Anspruch 2 oder 4, das ferner Anzeigeteile umfasst, die dafür ausgelegt sind, Signale der Anzeigeschaltung für den Ladezustand (53i1, 53i2, 53i3) zu empfangen und den schwachen Ladezustand, den abgeschlossenen Ladezustand und die Prioritätsreihenfolgen anzuzeigen; die Anzeigeteile sind dafür ausgelegt, mit der Vielzahl von Einspeiseeinheiten (PPᵢ₁, PPi2, PPi3, ...) an den vorderen Endteilen der Vielzahl von Regalböden (211, 212, 213, ...) gekoppelt zu werden.

6. Ladesystem nach Anspruch 3, wobei die Vielzahl von Einspeiseeinheiten (PPᵢ₁, PPᵢ₂, PPᵢ₃, ...) auf einer Seitenfläche des Säulenteils (29) entlang einer Höhenrichtung angeordnet ist.

7. Ladesystem nach Anspruch 3 oder 6, das ferner Anzeigeteile umfasst, die dafür ausgelegt sind, Signale von der Ladezustands-Anzeigeschaltung (53ᵢ₁, 53ᵢ₂, 53ᵢ₃) zu empfangen und den schwachen Ladezustand, den abgeschlossenen Ladezustand und die Prioritätsreihenfolgen anzuzeigen; die Anzeigeteile sind dafür ausgelegt, mit der Vielzahl von Einspeiseeinheiten (PPᵢ₁, PPᵢ₂, PPᵢ₃, ...) auf der Anzeigetafel 21 gekoppelt zu werden.

8. Ladesystem nach Anspruch 1, wobei die Bestimmungsschaltung für den Ladezustand umfasst:
eine Erfassungsschaltung für den Ladeendpunkt (521ᵢ₁, 521ᵢ₂, 521ᵢ₃, ...), die dafür ausgelegt ist, den Lade-Startzeitpunkt und den Lade- Endzeitpunkt festzustellen durch unabhängiges Messen der Änderung im Strom, der vom kommerziellen Stromnetz (590) jeder der zum Laden vorgesehenen Vorrichtungen zugeführt wird, die durch eine der Vielzahl von Einspeiseeinheiten (PPᵢ₁, PPᵢ₂, PPᵢ₃ ...) geladen werden; und
eine Referenz-Ladezeit-Bestimmungsschaltung (522ᵢ₁, 522ᵢ₂, 522ᵢ₃, ...), die dafür ausgelegt ist, Informationen über den Lade-Startzeitpunkt von der Erfassungsschaltung für den Ladeendpunkt (521ᵢ₁, 521ᵢ₂, 521ᵢ₃, ...) zu erhalten und eine vorgegebene Referenz-Ladezeit durch den Lade-Startzeitablauf der zum Laden vorgesehenen Vorrichtungen zu messen.

9. Ladesystem nach Anspruch 1, das ferner eine Fehlerstrom-Bestimmungsschaltung (55ᵢ₁, 55ᵢ₂, 55ᵢ₃) umfasst, die dafür ausgelegt ist, das Vorhandensein oder Nichtvorhandensein eines Fehlerstroms in jeder der Vielzahl der zum Laden vorgesehenen Vorrichtungen festzustellen.

## Revendications

1. Système de charge comprenant :
un mécanisme de montage permettant de monter simultanément une pluralité de dispositifs prévus pour être chargés ;
une pluralité d'unités distinctes d'alimentation en énergie (PPᵢ₁, PPᵢ₂, PPᵢ₃, ...) attachées respectivement au mécanisme de montage, qui sont agencées séparément pour la pluralité de dispositifs prévus pour être chargés, de sorte que la pluralité des unités d'alimentation en énergie (PPᵢ₁, PPᵢ₂, PPᵢ₃, ...) peuvent être connectées simultanément à la pluralité des dispositifs prévus pour être chargés, respectivement ;
un circuit de détermination d'état de charge attaché au mécanisme de montage, configuré pour déterminer des états de charge des dispositifs prévus pour être chargés, en mesurant séparément un courant fourni à partir d'une énergie commerciale (590) à chacun des dispositifs prévus pour être chargés, qui est chargé au travers de l'une quelconque de la pluralité d'unités d'alimentation en énergie (PPᵢ₁, PPᵢ₂, PPᵢ₃, ...) ;
un circuit de détermination de priorité (523ᵢ) attaché au mécanisme de montage, configuré pour déterminer un ordre de priorité dans la pluralité des dispositifs prévus pour être chargés sur la base des états de charge des dispositifs prévus pour être chargés, dans une condition telle que la pluralité de dispositifs prévus pour être chargés, qui comprennent des dispositifs prévus pour être chargés dont la charge est terminée, sont reliés à la pluralité d'unités d'alimentation en énergie (PPᵢ₁, PPᵢ₂, PPᵢ₃, ...) ; et
un circuit d'affichage d'état de charge (53ᵢ₁, 53ᵢ₂, 53ᵢ₃) configuré pour afficher si chacun de la pluralité des dispositifs prévus pour être chargés est dans un état de charge en cours ou dans un état de charge terminée, et pour afficher les ordres de priorité pour utiliser la pluralité des dispositifs prévus pour être chargés.

2. Système de charge selon la revendication 1, dans lequel le système de montage comprend un bâti comportant une pluralité d'étagères (211, 212, 213), et la pluralité d'unités d'alimentation en énergie (PPᵢ₁, PPᵢ₂, PPᵢ₃, ...) sont agencées respectivement sur la pluralité d'étagères (21₁, 21₂, 21₃, ...) .

3. Système de charge selon la revendication 1, dans lequel le mécanisme de montage comprend une tour comprenant :
un panneau d'affichage en forme de caisson (21) s'étendant dans le sens de la hauteur, et
une partie pilier en forme de caisson (29) reliée à une partie centrale d'une des faces latérales du panneau d'affichage (21) de manière à produire une forme en « T » vue en coupe transversale suivant un plan horizontal,
dans lequel la pluralité de dispositifs prévus pour être chargés sont agencés sur une paroi latérale de la tour.

4. Système de charge selon la revendication 2, dans lequel sont agencés une pluralité de capteurs détectant la présence d'une charge, configurés pour être associés à la pluralité d'unités d'alimentation en énergie (PPᵢ₁, PPᵢ₂, PPᵢ₃, ...) sur la pluralité d'étagères (21₁, 21₂, 21₃, ...) .

5. Système de charge selon les revendications 2 ou 4, comprenant en outre des parties d'affichage configurées pour recevoir des signaux du circuit d'affichage d'état de charge (53ᵢ₁, 53ᵢ₂, 53ᵢ₃) et pour afficher un état de charge en cours, l'état de charge terminée et les ordres de priorité, les parties d'affichage sont agencées pour être associées à la pluralité d'unités d'alimentation en énergie (PPᵢ₁, PPᵢ₂, PPᵢ₃, ...) dans des parties d'extrémité avant de la pluralité d'étagères (21₁, 21₂, 21₃, ...) .

6. Système de charge selon la revendication 3, dans lequel la pluralité d'unités d'alimentation en énergie (PPᵢ₁, PPᵢ₂, PPᵢ₃, ...) sont agencées sur une face latérale de la partie pilier 29 dans le sens de la hauteur.

7. Système de charge selon les revendications 3 ou 6, comprenant en outre des parties d'affichage configurées pour recevoir des signaux émanant du circuit d'affichage d'état de charge (53ᵢ₁, 53ᵢ₂, 53ᵢ₃) et pour afficher l'état de charge en cours, l'état de charge terminée et les ordres de priorité, les parties d'affichage sont agencées pour être associées à la pluralité d'unités d'alimentation en énergie (PPᵢ₁, PPᵢ₂, PPᵢ₃, ...) sur le panneau d'affichage 21.

8. Système de charge selon la revendication 1, dans lequel le circuit de détermination d'état de charge comprend :
un circuit de détection de fin de charge (521ᵢ₁, 521ᵢ₂, 521ᵢ₃, ...) configuré pour détecter un temps de début de charge et un temps de fin de charge de chacun des dispositifs prévus pour être chargés, en mesurant séparément une variation d'un courant fourni à partir d'une énergie commerciale (590) à chacun des dispositifs prévus pour être chargés, qui est chargé au travers de l'une quelconque de la pluralité d'unités d'alimentation en énergie (PPᵢ₁, PPᵢ₂, PPᵢ₃, ...) ; et
un circuit de détermination de période de charge de référence (522ᵢ₁, 522ᵢ₂, 522ᵢ₃, ...) configuré pour recevoir une indication du temps de début de charge en provenance du circuit de détection de fin de charge (521ᵢ₁, 521ᵢ₂, 521ᵢ₃, ...) et pour mesurer une période de charge de référence prédéterminée au travers du temps de début de charge des dispositifs prévus pour être chargés.

9. Système de charge selon la revendication 1, comprenant en outre un circuit de détermination de défaut de fuite à la terre (55ᵢ₁, 55ᵢ₂, 55ᵢ₃) configuré pour déterminer l'existence ou la non-existence d'un défaut de fuite à la terre dans chacun des dispositifs prévus pour être chargés.
